# EUROPEAN PATENT APPLICATION

(11) **EP 4 546 994 A2**
(43) Date of publication of application: **30.04.2025**
(21) Application number: 24204026.9
(22) Date of filing: 01.10.2024
(51) Int. Cl.: H10K 59/80

(54) **DISPLAY DEVICE AND METHOD OF MANUFACTURING THE SAME**

(30) Priority: 24.10.2023 KR 20230143011
(71) Applicant: Samsung Display Co., Ltd., Gyeonggi-do 17113 (KR)
(72) Inventor: KWON, Seung Wook, Yongin-si (KR); MUN, Hyo Young, Yongin-si (KR); KIM, Sun Hwa, Yongin-si (KR); SONG, Seung Yong, Yongin-si (KR); SHIM, Chang Woo, Yongin-si (KR); AHN, Sang Tae, Yongin-si (KR); UM, Yi Seul, Yongin-si (KR); YOON, Hee Chang, Yongin-si (KR); CHAE, Seung Yeon, Yongin-si (KR)
(74) Representative: Marks & Clerk LLP

(57) **Abstract**

A display device includes a display panel including a display area and a non-display area adjacent to a side of the display area, and a residue trace disposed on the display panel, and disposed on the display area and the non-display area, wherein an outer boundary of the residue trace is adjacent to an edge portion of the display panel, and disposed to be closer to a center portion of the display panel than the edge portion of the display panel.

## Description

### BACKGROUND

### 1. Technical Field

Embodiments relate to a display device and a method of manufacturing the display device.

### 2. Description of the Related Art

With the advance of information-oriented society, more and more demands are placed on display devices for displaying images in various ways. The display device may be a flat panel display device such as a liquid crystal display, a field emission display, and a light emitting display.

The display device includes a display area for displaying an image and a non-display area disposed around the display area, for example, to surround the display area. Recently, the width of the non-display area has been gradually reduced to increase immersion in the display area and enhance the aesthetics of the display device.

In the manufacturing process of the display device, the display device may be formed by cutting a mother substrate along display cells formed on the mother substrate including the display cells.

The non-display area may include a first non-display area in which lines and circuits for driving the display area are disposed, and a second non-display area corresponding to a margin for a cutting process in a manufacturing process of a display device. Since there is a limitation on reducing lines and circuits in the first non-display area, a method of reducing the width of the second non-display area is being researched.

### SUMMARY

Aspects of the disclosure provide a display device capable of minimizing a width of a non-display area and a method of manufacturing the display device.

Aspects of the disclosure also provide a display device capable of improving process efficiency and process yield, and a method of manufacturing the display device.

However, aspects of the disclosure are not restricted to those set forth herein. The above and other aspects of the disclosure will become more apparent to one of ordinary skill in the art to which the disclosure pertains by referencing the detailed description of the disclosure given below.

According to an aspect of the disclosure, there is provided a display device including, a display panel including a display area and a non-display area adjacent to a side of the display area, and a residue trace disposed on the display panel, and disposed on the display area and the non-display area, wherein an outer boundary of the residue trace may be adjacent to an edge portion of the display panel, and disposed to be closer to a center portion of the display panel than the edge portion of the display panel.

In an embodiment, the outer boundary of the residue trace may be surrounded by an outer boundary of the display panel in plan view.

In an embodiment, the display panel may include a crack dam adjacent to the edge portion of the display panel, and the outer boundary of the residue trace closer to the center portion of the display panel than the crack dam.

In an embodiment, the display panel may include a through hole penetrating the display panel and disposed in the display area, and the residue trace may include an opening surrounding the through hole.

In an embodiment, the opening of the residue trace may be larger than the through hole of the display panel in plan view.

In an embodiment, in plan view, the opening of the residue trace and the through hole of the display panel may have different sizes and a same shape.

According to an aspect of the disclosure, there is provided a display device including, a display panel including at least one conductive layer and at least one non-conductive layer disposed on the conductive layer, and a residue trace disposed on at least a part of the non-conductive layer, wherein a light transmittance of the non-conductive layer in a first area, in which the residue trace is disposed, is different from a light transmittance of the non-conductive layer in a second area in which the residue trace is not disposed.

In an embodiment, the residue trace may be smaller than the display panel in plan view.

In an embodiment, the residue trace may include at least one of acrylic resin, epoxy resin, and urethane resin.

In an embodiment, the residue trace may be formed in a process in which a part of the non-conductive layer is removed.

In an embodiment, the display panel may include, a substrate, a light emitting element layer disposed on the substrate, and an encapsulation layer disposed on the light emitting element layer, wherein the residue trace may be disposed on the encapsulation layer.

In an embodiment, the encapsulation layer may include a first encapsulation inorganic layer, an organic layer disposed on the first encapsulation inorganic layer, and a second encapsulation inorganic layer disposed on the organic layer, and the residue trace may be disposed on the second encapsulation inorganic layer.

In an embodiment, the display panel may include, a substrate, a light emitting element layer disposed on the substrate, an encapsulation layer disposed on the light emitting element layer, and a sensor electrode layer disposed on the encapsulation layer, wherein the residue trace may be disposed on the sensor electrode layer.

In an embodiment, the sensor electrode layer may include a sensor electrode and a sensor insulating layer, and the residue trace may be disposed on the sensor insulating layer.

According to an aspect of the disclosure, there is provided a method of manufacturing a display device, including, forming a plurality of display cells on a mother substrate, forming a coating layer on each of the plurality of display cells, forming a plurality of first laser irradiation areas by irradiating a first laser to the mother substrate, attaching a protective film on the mother substrate, and cutting the mother substrate along the plurality of first laser irradiation areas by spraying an etchant on the mother substrate without a mask.

In an embodiment, forming of the coating layer may include, applying resin, and curing the resin.

In an embodiment, the resin may be applied by a printing process.

In an embodiment, the coating layer may include an inclined surface at an end portion of the coating layer.

In an embodiment, an angle of a tangent line with respect to the inclined surface at the end portion of the coating layer may be equal to or less than about 30 degrees.

In an embodiment, the coating layer may include, an inclined portion adjacent to the end portion of the coating layer, and a flat portion disposed on a side of the inclined portion.

In an embodiment, the method may further comprise removing the coating layer, wherein in the removing of the coating layer, an adhesive force of the coating layer in the inclined portion may be greater than an adhesive force of the coating layer in the flat portion.

In an embodiment, an adhesive force of the coating layer in the inclined portion may be about 10 gf/inch to about 150 gf/inch, and an adhesive force of the coating layer in the flat portion may be about 5 gf/inch to about 10 gf/inch.

In an embodiment, the coating layer may include at least one of acrylic resin, epoxy resin, and urethane resin.

In an embodiment, an average thickness of the coating layer may be about 40 µm to about 150 µm.

In an embodiment, the protective film may include at least one of polyethylene terephthalate (PET), polypropylene (PP), polycarbonate (PC), polyethylene (PE), and polyvinyl chloride (PVC).

In an embodiment, the protective film may include an adhesive layer, and the adhesive layer may include at least one of silicone-based, polyurethane-based, and acrylic-based materials.

At least some of the above and other features of the invention are set out in the claims.

According to the display device and the method of manufacturing the display device according to an embodiment, the width of the non-display area may be minimized.

In the display device and the method of manufacturing the display device according to an embodiment, process efficiency and process yield may be improved.

However, effects according to the embodiments are not limited to those examples above and various other effects are incorporated herein.

### BRIEF DESCRIPTION OF THE DRAWINGS

The above and other aspects and features of the disclosure will become more apparent by describing in detail embodiments thereof with reference to the attached drawings, in which:
FIG. 1 is a schematic perspective view showing a display device according to an embodiment;
FIG. 2 is a schematic plan view illustrating a display panel and a driving integrated circuit (IC) according to an embodiment;
FIG. 3 is a schematic cross-sectional view taken along line X1-X1' of FIG. 1;
FIG. 4 is a schematic cross-sectional view showing the display device of FIG. 3 in a bent state;
FIG. 5 is a schematic cross-sectional view illustrating an example of a display area of a display device according to an embodiment;
FIG. 6 is an enlarged schematic view of area A of FIG. 2;
FIG. 7 is a schematic cross-sectional view taken along line X2-X2' of FIG. 6;
FIG. 8 is an enlarged schematic view of area C of FIG. 7;
FIG. 9 is an enlarged schematic view of area B of FIG. 2;
FIG. 10 is a schematic cross-sectional view taken along line X3-X3' of FIG. 9;
FIG. 11 is an enlarged schematic view of area D of FIG. 10;
FIG. 12 is a series of photographs illustrating a process through which a residue trace of a display device according to an embodiment is formed;
FIG. 13 is a flowchart showing a method of manufacturing a display device according to an embodiment;
FIG. 14 is a schematic diagram illustrating the depth of a laser irradiation area formed by a laser processing device according to an embodiment;
FIG. 15 is a schematic perspective view showing step S110 of FIG. 13;
FIG. 16 is a schematic perspective view showing step S120 of FIG. 13;
FIG. 17 is a schematic perspective view showing step S130 of FIG. 13;
FIG. 18 is a schematic perspective view showing step S140 of FIG. 13;
FIG. 19 is a schematic perspective view showing step S160 of FIG. 13;
FIG. 20 is a schematic plan view showing step S160 of FIG. 13;
FIG. 21 is a schematic perspective view showing step S160 of FIG. 13;
FIG. 22 is a schematic perspective view showing step S170 of FIG. 13;
FIG. 23 is a schematic cross-sectional view showing step S120 of FIG. 13;
FIG. 24 is a schematic cross-sectional view showing a coating layer according to an embodiment;
FIG. 25 is a schematic cross-sectional view showing step S130 of FIG. 13;
FIG. 26 is a schematic cross-sectional view showing step S160 of FIG. 13;
FIG. 27 is a schematic cross-sectional view showing step S160 of FIG. 13;
FIG. 28 is a schematic cross-sectional view showing step S170 of FIG. 13;
FIG. 29 is a schematic cross-sectional view showing step S120 of FIG. 13;
FIG. 30 is a schematic cross-sectional view showing step S140 of FIG. 13;
FIG. 31 is a schematic cross-sectional view showing step S160 of FIG. 13;
FIG. 32 is a schematic cross-sectional view showing step S160 of FIG. 13;
FIG. 33 is a schematic cross-sectional view showing step S170 of FIG. 13;
FIG. 34 is a photograph showing a through hole and the vicinity thereof according to a comparative example; and
FIG. 35 is a photograph showing a through hole and the vicinity thereof according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction, the axis of the second direction, and the axis of the third direction are not limited to three axes of a rectangular coordinate system, such as the X, Y, and Z - axes, and may be interpreted in a broader sense. For example, the axis of the first direction, the axis of the second direction, and the axis of the third direction may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described in detail with reference to the accompanying drawings.

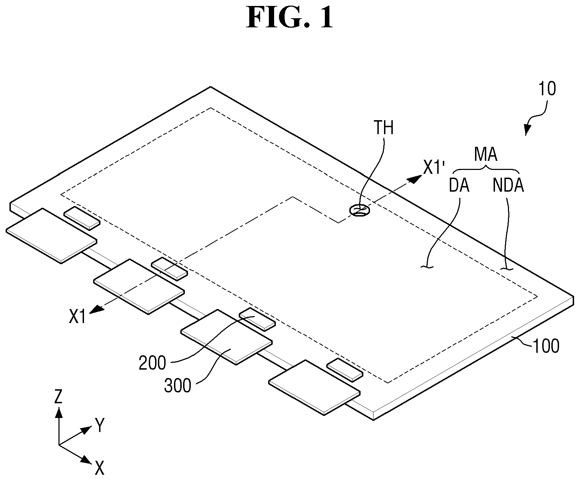

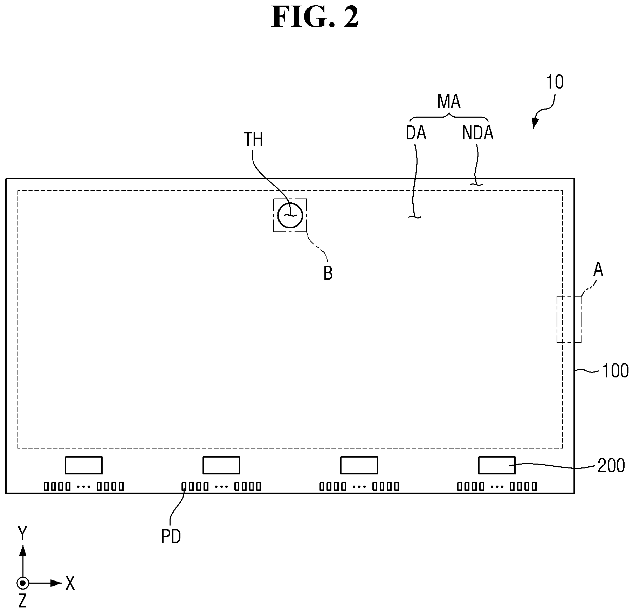

FIG. 1 is a schematic perspective view showing a display device 10 according to an embodiment. FIG. 2 is a schematic plan view illustrating a display panel 100 and a driving integrated circuit (IC) 200 according to an embodiment.

Referring to FIGS. 1 and 2, a display device 10 may be a device for displaying a moving image or a still image. The display device 10 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

The display device 10 according to an embodiment may be a light emitting display device such as an organic light emitting display using an organic light emitting diode, a quantum dot light emitting display including a quantum dot light emitting layer, an inorganic light emitting display including an inorganic semiconductor, a micro light emitting display using a micro light emitting diode (LED), and a nano light emitting display using a nano light emitting diode (LED). In the following description, the display device 10 may be an organic light emitting display device, but embodiments are not limited thereto.

The display device 10 according to an embodiment may include a display panel 100, a driving integrated circuit (IC) 200, and a circuit board 300.

The display panel 100 may be formed in a rectangular shape, in plan view, having long sides in a first direction (e.g., X-axis direction) and short sides in a second direction (e.g., Y-axis direction) crossing the first direction (e.g., X-axis direction). A corner portion formed by the long side in the first direction (e.g., X-axis direction) and the short side in the second direction (e.g., Y-axis direction) may be right-angled or rounded at a curvature. The planar shape of the display panel 100 is not limited to the rectangular shape, and may be formed in another polygonal shape, a circular shape or an elliptical shape.

In the drawings, the first direction (e.g., X-axis direction) and the second direction (e.g., Y-axis direction) may intersect each other, and may be horizontal directions. For example, the first direction (e.g., X-axis direction) and the second direction (e.g., Y-axis direction) may be orthogonal to each other. For example, the third direction (e.g., Z-axis direction) may intersect the first direction (e.g., X-axis direction) and the second direction (e.g., Y-axis direction), and may be, for example, perpendicular directions orthogonal to each other. In the description, directions indicated by arrows of the first to third directions (e.g., X-axis direction, Y-axis direction, and Z-axis direction) may be referred to as a side, and the opposite directions thereto may be referred to as another side.

The display panel 100 may be formed to be flat, but embodiments are not limited thereto. For example, the display panel 100 may include a curved portion formed at left and right end portions and having a constant curvature or a varying curvature. For example, the display panel 100 may be formed flexibly so that it may be curved, bent, folded, or rolled.

The display panel 100 may include a display area DA displaying an image and a non-display area NDA disposed around the display area DA. The display area DA and the non-display area NDA may form a main area MA.

The display area DA may occupy most of the area of the display panel 100. The display area DA may be disposed at the center of the display panel 100. Pixels each including emission areas may be disposed in the display area DA to display an image.

The non-display area NDA may be disposed adjacent to the display area DA. The non-display area NDA may be an area outside the display area DA. The non-display area NDA may be disposed to surround the display area DA. The non-display area NDA may be an edge area of the display panel 100.

Display pads PD may be arranged in the non-display area NDA to be connected to the circuit boards 300. The display pads PD may be disposed on a side edge portion of the display panel 100. For example, the display pads PD may be disposed at the lower edge portion of the display panel 100.

The driving ICs 200 may generate the data voltages, the source voltages, the scan timing signals, and the like. The driving ICs 200 may output the data voltages, the source voltages, the scan timing signals, and the like.

The driving ICs 200 may be disposed between the display pads PD and the display area DA in the non-display area NDA. Each of the driving ICs 200 may be attached to the non-display area NDA of the display panel 100 in a chip on glass (COG) method. In another example, each of the driving ICs 200 may be attached to the circuit board 300 in a chip on plastic (COP) method.

The circuit boards 300 may be disposed on the display pads PD disposed on a side edge portion of the display panel 100. The circuit boards 300 may be attached to the display pads PD by using a conductive adhesive member such as an anisotropic conductive film and an anisotropic conductive adhesive. Accordingly, the circuit boards 300 may be electrically connected to the signal lines of the display panel 100. The circuit boards 300 may be a flexible printed circuit board or a flexible film such as a chip on film.

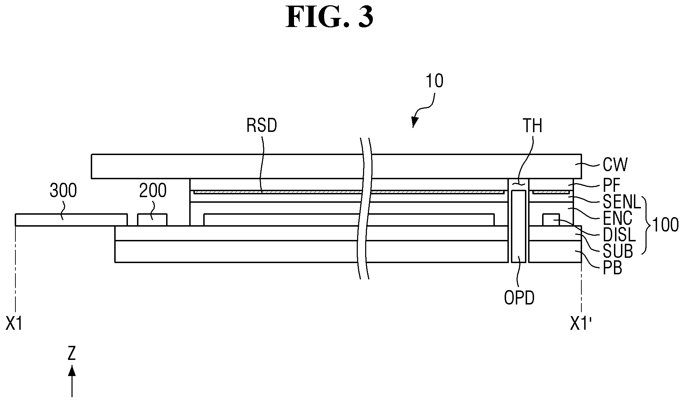

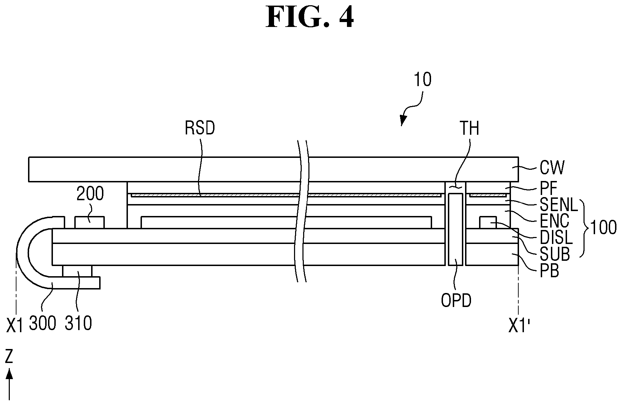

FIG. 3 is a schematic cross-sectional view taken along line X1-X1' of FIG. 1. FIG. 4 is a schematic cross-sectional view showing the display device 10 of FIG. 3 in a bent state.

Referring to FIGS. 3 and 4 in addition to FIGS. 1 and 2, the display device 10 according to an embodiment may include the display panel 100, a polarizing film PF, a cover window CW, a panel lower cover PB, the driving IC 200, and the circuit board 300. The display panel 100 may include a substrate SUB, a display layer DISL, an encapsulation layer ENC, and a sensor electrode layer SENL.

The substrate SUB may have a hard material. For example, the substrate SUB may be made of glass. The substrate SUB may be formed of ultra-thin glass (UTG) having a thickness of about 500 µm or less. For example, the thickness of the substrate SUB may be about 200 µm. In another embodiment, the substrate SUB may include a first substrate made of a hard material and a second substrate made of polymer resin made of a flexible material.

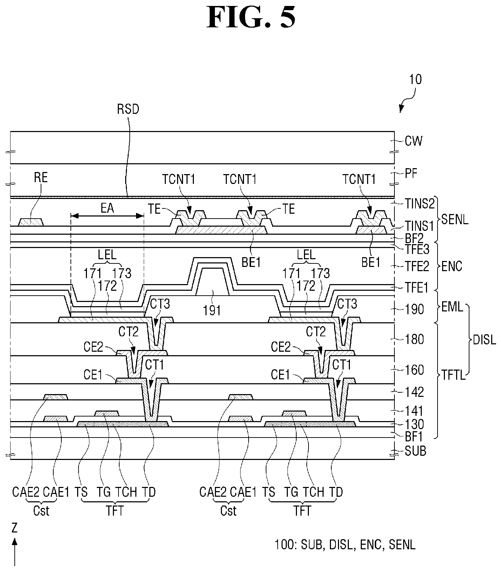

The display layer DISL may be disposed on the first surface of the substrate SUB. The display layer DISL may be a layer displaying an image. The display layer DISL may include a thin film transistor layer TFTL (see FIG. 5) in which thin film transistors are formed, and a light emitting element layer EML (see FIG. 5) in which light emitting elements emitting light are disposed in the emission areas.

In the display area DA of the display layer DISL, scan lines, data lines, power lines, or the like for the emission areas to emit light may be disposed. In the non-display area NDA of the display layer DISL, a scan driving circuit unit outputting scan signals to the scan lines, fan-out lines connecting the data lines and the driving IC 200, and the like may be disposed.

The encapsulation layer ENC may be a layer for encapsulating the light emitting element layer EML of the display layer DISL to prevent permeation of oxygen or moisture into the light emitting element layer EML of the display layer DISL. The encapsulation layer ENC may be disposed on the display layer DISL. The encapsulation layer ENC may be disposed on the top surfaces (or upper surfaces) and the side surfaces of the display layer DISL. The encapsulation layer ENC may be disposed to cover the display layer DISL.

The sensor electrode layer SENL may be disposed on the display layer DISL. The sensor electrode layer SENL may include sensor electrodes. The sensor electrode layer SENL may sense a user's touch using sensor electrodes.

The polarizing film PF may be disposed on the sensor electrode layer SENL. The polarizing film PF may be disposed on the display panel 100 to reduce reflection of external light. The polarizing film PF may include a first base member, a linear polarization plate, a phase retardation film such as a quarter-wave plate (λ/4 plate), and a second base member. The first base member, the phase retardation film, the linear polarization plate, and the second base member of the polarizing film PF may be sequentially stacked on the display panel 100.

The cover window CW may be disposed on the polarizing film PF. The cover window CW may be attached on the polarizing film PF by a transparent adhesive member such as an optically clear adhesive (OCA) film.

The panel lower cover PB may be disposed on a second surface of the substrate SUB of the display panel 100. The second surface of the substrate SUB may be a surface opposite to the first surface. The panel lower cover PB may be attached to the second surface of the substrate SUB of the display panel 100 through an adhesive member. The adhesive member may be a pressure sensitive adhesive (PSA).

The panel lower cover PB may include at least one of a light blocking member for absorbing light incident from the outside, a buffer member for absorbing an impact from the outside, or a heat dissipation member for efficiently dissipating heat from the display panel 100.

The driving IC 200 and the circuit board 300 may be bent downward of the display panel 100 as illustrated in FIG. 4. The circuit board 300 may be attached to the bottom surface (or lower surface) of the panel lower cover PB by an adhesive member 310. The adhesive member 310 may be a pressure sensitive adhesive.

The display device 10 may further include a through hole TH and an optical device OPD disposed in the through hole TH.

The through hole TH may be a hole capable of transmitting light, and may be a physical hole penetrating not only the display panel 100 but also the panel lower cover PB and the polarizing film PF. For example, the through hole TH may penetrate the substrate SUB, the display layer DISL, the encapsulation layer ENC, and the sensor electrode layer SENL of the display panel 100. However, embodiments are not limited thereto, and the through hole TH may penetrate the panel lower cover PB but may not penetrate the display panel 100 and the polarizing film PF. The cover window CW may be disposed to cover the through hole TH.

The optical device OPD may be spaced apart from the display panel 100, the panel lower cover PB, and the polarizing film PF. The optical device OPD may be an optical sensor that senses light incident through the through hole TH, such as a proximity sensor, an illuminance sensor, and a camera sensor.

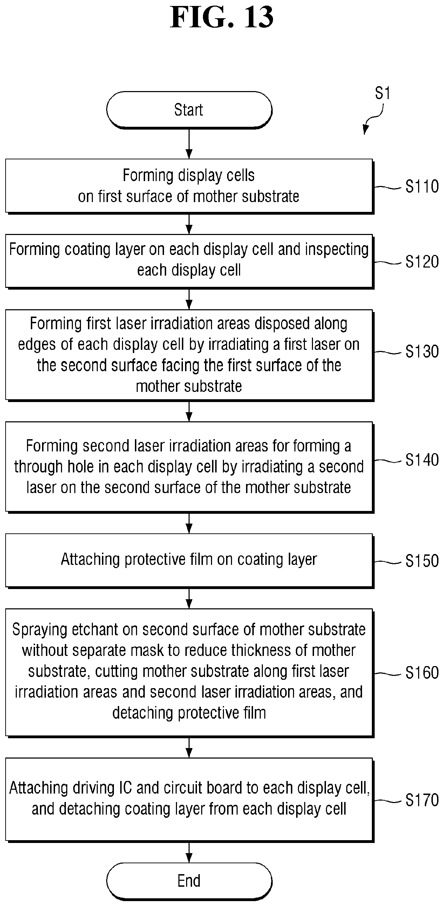

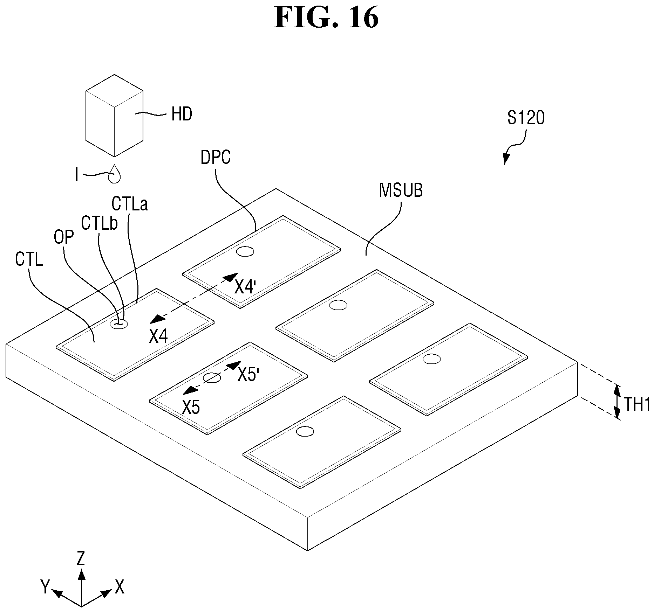

The display device 10 according to an embodiment includes a residue trace RSD disposed on the display panel 100. For example, the residue trace RSD may be disposed between the display panel 100 and the polarizing film PF. The residue trace RSD may be a removal trace that is formed in the case that a coating layer CTL (see FIG. 16) is removed in a manufacturing method S1 (see FIG. 13) for a display device to be described later.

In some embodiments, as illustrated in the drawings, the residue trace RSD may be disposed on the sensor electrode layer SENL. However, embodiments are not limited thereto, and in the case that the sensor electrode layer SENL is omitted, the residue trace RSD may be disposed on the encapsulation layer ENC.

FIG. 5 is a schematic cross-sectional view illustrating an example of a display area of a display device according to an embodiment.

Referring to FIG. 5, the display device 10 according to an embodiment may include the display panel 100, the polarizing film PF, and the cover window CW.

In an embodiment, the display panel 100 may be an organic light emitting display panel having a light emitting element LEL including an organic light emitting layer 172. The display panel 100 may include the substrate SUB, the display layer DISL, the encapsulation layer ENC, and the sensor electrode layer SENL. The display layer DISL may include the thin film transistor layer TFTL including thin film transistors and the light emitting element layer EML including light emitting elements.

The substrate SUB may have a hard material. For example, the substrate SUB may be made of glass. The substrate SUB may be formed of ultra-thin glass (UTG) having a thickness of about 500 µm or less. For example, the thickness of the substrate SUB may be about 200 µm. In another embodiment, the substrate SUB may include a first substrate made of a hard material and a second substrate made of polymer resin made of a flexible material.

The display layer DISL may include the thin film transistor layer TFTL including thin film transistors and the light emitting element layer EML including light emitting elements.

The thin film transistor layer TFTL may include a first buffer layer BF1, a thin film transistor TFT, a gate insulating layer 130, a first interlayer insulating layer 141, a capacitor Cst, a second interlayer insulating layer 142, a first data metal layer, a first organic layer 160, a second data metal layer, and a second organic layer 180.

The first buffer layer BF1 may be disposed on the substrate SUB. The first buffer layer BF1 may be formed of an inorganic material such as a silicon nitride layer, a silicon oxynitride layer, a silicon oxide layer, a titanium oxide layer and an aluminium oxide layer. In another example, the first buffer layer BF1 may be formed as a multilayer in which a plurality of layers selected from a silicon nitride layer, a silicon oxynitride layer, a silicon oxide layer, a titanium oxide layer and an aluminium oxide layer are alternately stacked.

An active layer including a channel region TCH, a source region TS, and a drain region TD of the thin film transistor TFT may be disposed on the first buffer layer BF1. The active layer may be formed of polycrystalline silicon, monocrystalline silicon, low-temperature polycrystalline silicon, amorphous silicon, or an oxide semiconductor material. In the case that the active layer includes polycrystalline silicon or an oxide semiconductor material, the source region TS and the drain region TD of the active layer may be conductive regions doped with ions or impurities and having conductivity.

The gate insulating layer 130 may be disposed on the active layer of the thin film transistor TFT. The gate insulating layer 130 may be formed of an inorganic layer, for example, a silicon nitride layer, a silicon oxynitride layer, a silicon oxide layer, a titanium oxide layer, or an aluminium oxide layer.

A first gate metal layer including a gate electrode TG of the thin film transistor TFT, a first capacitor electrode CAE1 of the capacitor Cst, and scan lines may be disposed on the gate insulating layer 130. The gate electrode TG of the thin film transistor TFT may overlap the channel region TCH in the third direction (e.g., Z-axis direction). The first gate metal layer may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

The first interlayer insulating layer 141 may be disposed on the first gate metal layer. The first interlayer insulating layer 141 may be formed of an inorganic layer, for example, a silicon nitride layer, a silicon oxynitride layer, a silicon oxide layer, a titanium oxide layer, or an aluminium oxide layer. The first interlayer insulating layer 141 may include inorganic layers.

A second gate metal layer including a second capacitor electrode CAE2 of the capacitor Cst may be disposed on the first interlayer insulating layer 141. The second capacitor electrode CAE2 may overlap the first capacitor electrode CAE1 in the third direction (e.g., Z-axis direction). Therefore, the capacitor Cst may be formed by the first capacitor electrode CAE1, the second capacitor electrode CAE2, and an inorganic insulating dielectric layer, which is disposed between the first capacitor electrode CAE1 and the second capacitor electrode CAE2, to function as a dielectric layer. The second gate metal layer may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

The second interlayer insulating layer 142 may be disposed on the second gate metal layer. The second interlayer insulating layer 142 may be formed of an inorganic layer, for example, a silicon nitride layer, a silicon oxynitride layer, a silicon oxide layer, a titanium oxide layer, or an aluminium oxide layer. The second interlayer insulating layer 142 may include inorganic layers.

The first data metal layer including a first connection electrode CE1 and the data lines may be disposed on the second interlayer insulating layer 142. The first connection electrode CE1 may be connected to the drain region TD through a first contact hole CT1 penetrating the gate insulating layer 130, the first interlayer insulating layer 141, and the second interlayer insulating layer 142. The first data metal layer may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof

The first organic layer 160 for flattening the stepped portion due to the thin film transistors TFT may be disposed on the first connection electrode CE1. The first organic layer 160 may be formed of an organic layer such as acryl resin, epoxy resin, phenolic resin, polyamide resin, polyimide resin and the like.

The second data metal layer including a second connection electrode CE2 may be disposed on the first organic layer 160. The second data metal layer may be connected to the first connection electrode CE1 through a second contact hole CT2 penetrating the first organic layer 160. The second data metal layer may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

The second organic layer 180 may be disposed on the second connection electrode CE2. The second organic layer 180 may be formed of an organic layer such as acryl resin, epoxy resin, phenolic resin, polyamide resin, polyimide resin and the like.

For example, the second data metal layer including the second connection electrode CE2 and the second organic layer 180 may be omitted.

The light emitting element layer EML may be disposed on the thin film transistor layer TFTL. The light emitting element layer EML may include light emitting elements LEL and a pixel defining layer 190.

Each of the light emitting elements LEL may include a pixel electrode 171, a light emitting layer 172, and a common electrode 173. Each of the emission areas EA may be an area in which the pixel electrode 171, the light emitting layer 172, and the common electrode 173 are sequentially stacked such that the holes from the pixel electrode 171 and the electrons from the common electrode 173 may be combined with each other to emit light. For example, the pixel electrode 171 may be an anode electrode, and the common electrode 173 may be a cathode electrode.

A pixel electrode layer including the pixel electrode 171 may be formed on the second organic layer 180. The pixel electrode 171 may be connected to the second connection electrode CE2 through a third contact hole CT3 penetrating the second organic layer 180. The pixel electrode layer may be formed as a single layer or multiple layers made of any one of molybdenum (Mo), aluminium (Al), chromium (Cr), gold (Au), titanium (Ti), nickel (Ni), neodymium (Nd) and copper (Cu) and an alloy thereof.

In a top emission structure (or upper emission member) that emits light toward the common electrode 173 with respect to the light emitting layer 172, the pixel electrode 171 may be formed of a single layer of molybdenum (Mo), titanium (Ti), copper (Cu), or aluminium (Al), or may be formed to have a stacked structure (Ti/Al/Ti) of aluminium and titanium, a stacked structure (ITO/Al/ITO) of aluminium and ITO, an APC alloy, or a stacked structure (ITO/APC/ITO) of APC alloy and ITO to increase the reflectivity. The APC alloy may be an alloy of silver (Ag), palladium (Pd) and copper (Cu).

The pixel defining layer 190 may function to define emission areas EA of pixels. For example, the pixel defining layer 190 may be formed to expose a partial region of the pixel electrode 171 on the second organic layer 180. The pixel defining layer 190 may cover an edge portion of the pixel electrode 171. The pixel defining layer 190 may be disposed in the third contact hole CT3. For example, the third contact hole CT3 may be filled with the pixel defining layer 190. The pixel defining layer 190 may be formed of an organic layer such as acryl resin, epoxy resin, phenolic resin, polyamide resin, polyimide resin and the like.

A spacer 191 may be disposed on the pixel defining layer 190. The spacer 191 may function to support a mask during a process of manufacturing the light emitting layer 172. The spacer 191 may be formed of an organic layer such as acryl resin, epoxy resin, phenolic resin, polyamide resin, polyimide resin and the like.

The light emitting layer 172 may be formed on the pixel electrode 171. The light emitting layer 172 may include an organic material to emit light in a selected color. For example, the light emitting layer 172 may include a hole transporting layer, an organic material layer, and an electron transporting layer. The organic material layer may include a host and a dopant. The organic material layer may include a material that emits selected light, and may be formed using a phosphorescent material or a fluorescent material.

The common electrode 173 may be formed on the light emitting layer 172. The common electrode 173 may be formed to cover the light emitting layer 172. The common electrode 173 may be a common layer formed in common on the emission areas EA. A capping layer may be formed on the common electrode 173.

In the top emission structure (or upper emission member), the common electrode 173 may be formed of a transparent conductive material (TCO) such as ITO or IZO capable of transmitting light or a semi-transmissive conductive material such as magnesium (Mg), silver (Ag), or an alloy of magnesium (Mg) and silver (Ag). In the case that the common electrode 173 is formed of a semi-transmissive conductive material, the light emission efficiency may be increased due to a micro-cavity effect.

The encapsulation layer ENC may be disposed on the light emitting element layer EML. The encapsulation layer ENC may include at least one inorganic layer TFE1 and TFE3 to prevent oxygen or moisture from permeating into the light emitting element layer EML. For example, the encapsulation layer ENC may include at least one organic layer TFE2 to protect the light emitting element layer EML from foreign substances such as dust. For example, the encapsulation layer ENC may include a first encapsulation inorganic layer TFE1, an encapsulation organic layer TFE2, and a second encapsulation inorganic layer TFE3.

The first encapsulation inorganic layer TFE1 may be disposed on the common electrode 173, the encapsulation organic layer TFE2 may be disposed on the first encapsulation inorganic layer TFE1, and the second encapsulation inorganic layer TFE3 may be disposed on the encapsulation organic layer TFE2. The first encapsulation inorganic layer TFE1 and the second encapsulation inorganic layer TFE3 may be formed of a multilayer in which one or more inorganic layers of a silicon nitride layer, a silicon oxynitride layer, a silicon oxide layer, a titanium oxide layer and an aluminium oxide layer are alternately stacked. The encapsulation organic layer TFE2 may be an organic layer such as acryl resin, epoxy resin, phenolic resin, polyamide resin, polyimide resin or the like.

The sensor electrode layer SENL may be disposed on the encapsulation layer ENC. The sensor electrode layer SENL may include a second buffer layer BF2, a first connection portion BE1, a first sensor insulating layer TINS1, sensor electrodes TE and RE, and a second sensor insulating layer TINS2. For example, the sensor electrodes TE may be connected to the first connection portion BE1 through contact holes TCNT1 passing through the first sensor insulating layer TINS 1.

The second buffer layer BF2 may be disposed on the encapsulation layer ENC. The second buffer layer BF2 may include at least one inorganic layer. For example, the second buffer layer BF2 may be formed of multiple layers in which one or more inorganic layers of a silicon nitride layer, a silicon oxynitride layer, a silicon oxide layer, a titanium oxide layer and an aluminium oxide layer are alternately stacked. The second buffer layer BF2 may be omitted.

The first connection portions BE1 may be disposed on the second buffer layer BF2. The first connection portions BE1 may be formed of a single layer including molybdenum (Mo), titanium (Ti), copper (Cu), or aluminium (Al), or may be formed to have a stacked structure (Ti/Al/Ti) of aluminium and titanium, a stacked structure (ITO/Al/ITO) of aluminium and indium tin oxide (ITO), an Ag-Pd-Cu (APC) alloy, or a stacked structure (ITO/APC/ITO) of APC alloy and ITO.

The first sensor insulating layer TINS1 may be disposed on the first connection portions BE1. The first sensor insulating layer TINS1 may be formed of an inorganic layer, for example, a silicon nitride layer, a silicon oxynitride layer, a silicon oxide layer, a titanium oxide layer, or an aluminium oxide layer.

The sensor electrodes, e.g., the driving electrodes TE and the sensing electrodes RE, may be disposed on the first sensor insulating layer TINS1. For example, dummy patterns may be disposed on the first sensor insulating layer TINS1. The driving electrodes TE, the sensing electrodes RE, and the dummy patterns may not overlap the emission areas EA. The driving electrodes TE, the sensing electrodes RE, and the dummy patterns may be formed of a single layer including molybdenum (Mo), titanium (Ti), copper (Cu), or aluminium (Al), or may be formed to have a stacked structure (Ti/Al/Ti) of aluminium and titanium, a stacked structure (ITO/Al/ITO) of aluminium and indium tin oxide (ITO), an Ag-Pd-Cu (APC) alloy, or a stacked structure (ITO/APC/ITO) of APC alloy and ITO.

The second sensor insulating layer TINS2 may be disposed on the driving electrodes TE, the sensing electrodes RE, and the dummy patterns. The second sensor insulating layer TINS2 may include at least one of an inorganic layer or an organic layer. The inorganic layer may be a silicon nitride layer, a silicon oxynitride layer, a silicon oxide layer, a titanium oxide layer, and an aluminium oxide layer. The organic layer may include acryl resin, epoxy resin, phenolic resin, polyamide resin, or polyimide resin.

The polarizing film PF may be disposed on the sensor electrode layer SENL. The polarizing film PF may be disposed on the display panel 100 to reduce (or minimize) reflection of external light. The polarizing film PF may include a first base member, a linear polarization plate, a phase retardation film such as a quarter-wave plate (λ/4 plate), and a second base member. The first base member, the phase retardation film, the linear polarization plate, and the second base member of the polarizing film PF may be sequentially stacked on the display panel 100.

The cover window CW may be disposed on the polarizing film PF. The cover window CW may be attached on the polarizing film PF by a transparent adhesive member such as an optically clear adhesive (OCA) film.

The display device 10 according to an embodiment includes the residue trace RSD. The residue trace RSD is disposed on the display panel 100. For example, as illustrated in the drawings, the residue trace RSD may be disposed on the sensor electrode layer SENL. In an embodiment, the residue trace RSD may be disposed on the second sensor insulating layer TINS2.

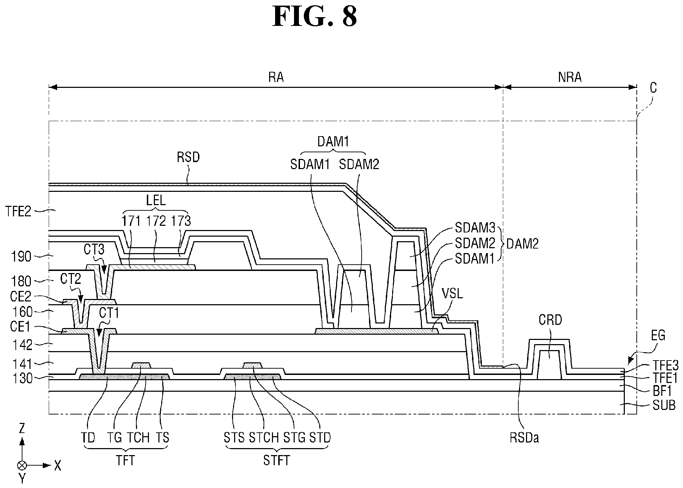

However, embodiments are not limited thereto, and in the case that the display device 10 does not include the sensor electrode layer SENL, the residue trace RSD may be disposed on the encapsulation layer ENC. In another embodiment, the residue trace RSD may be disposed on the second encapsulation inorganic layer TFE3 (see FIG. 8).

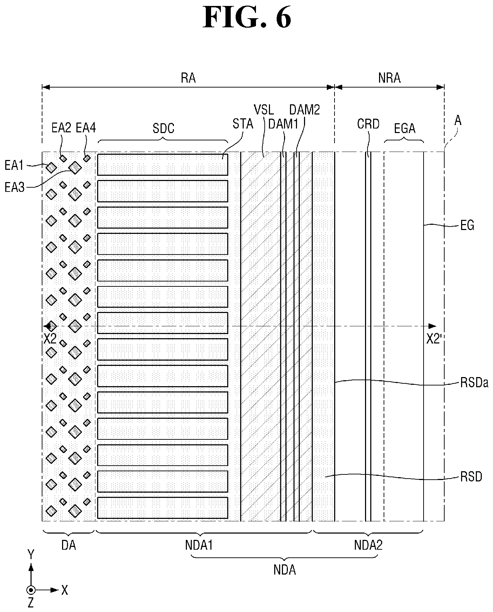

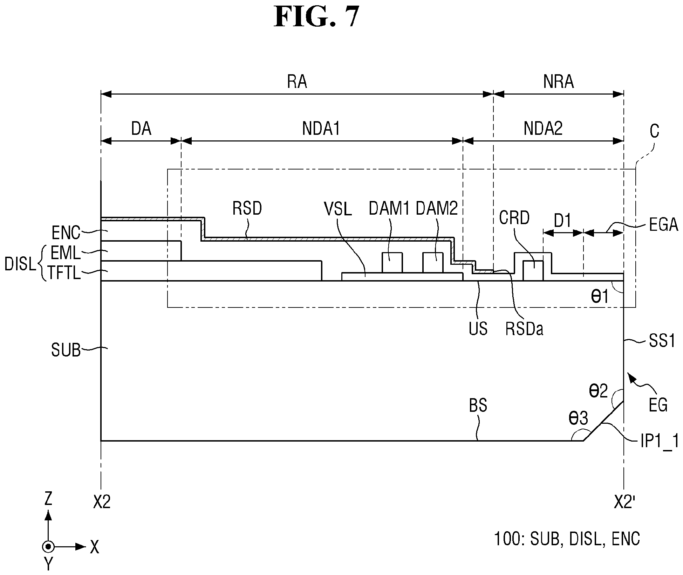

FIG. 6 is an enlarged schematic view of area A of FIG. 2. FIG. 7 is a schematic cross-sectional view taken along line X2-X2' of FIG. 6.

Referring to FIGS. 6 and 7 in addition to FIG. 5, the display area DA may include emission areas EA1, EA2, EA3, and EA4. The emission areas EA1, EA2, EA3, and EA4 may include the first emission area EA1 emitting light of a first color, the second emission area EA2 and the fourth emission area EA4 emitting light of a second color, and the third emission area EA3 emitting light of a third color. For example, light of the first color may be light in a red wavelength band of about 600 nm to about 750 nm, light of the second color may be light in a green wavelength band of about 480 nm to about 560 nm, and light of the third color may be light in a blue wavelength band of about 370 nm to about 460 nm, but embodiments are not limited thereto.

Although FIG. 6 illustrates that the second emission area EA2 and the fourth emission area EA4 emit light of the same color, e.g., light of the second color, embodiments are not limited thereto. The second emission area EA2 and the fourth emission area EA4 may emit light of different colors. For example, the second emission area EA2 may emit light of the second color, and the fourth emission area EA4 may emit light of a fourth color.

For example, in FIG. 6, although it is illustrated that each of the first emission areas EA1, the second emission areas EA2, the third emission areas EA3, and the fourth emission areas EA4 has a rectangular planar shape, embodiments are not limited thereto. Each of the first emission areas EA1, the second emission areas EA2, the third emission areas EA3, and the fourth emission areas EA4 may have a polygonal shape other than a quadrilateral shape, a circular shape, or an elliptical shape in plan view.

In some embodiments, the third emission area EA3 may have the largest area (or size), and the second emission area EA2 and the fourth emission area EA4 may have the smallest areas (or sizes). The area (or size) of the second emission area EA2 and the area (or size) of the fourth emission area EA4 may be the same as each other, but embodiments are not limited thereto.

The second emission areas EA2 and the fourth emission areas EA4 may be alternately disposed in the first direction (e.g., X-axis direction). The second emission areas EA2 may be disposed in the second direction (e.g., Y-axis direction). The fourth emission areas EA4 may be disposed in the second direction (e.g., Y-axis direction).

The first emission areas EA1 and the third emission areas EA3 may be alternately disposed in the first direction (e.g., X-axis direction). The first emission areas EA1 may be disposed in the second direction (e.g., Y-axis direction). The third emission areas EA3 may be disposed in the second direction (e.g., Y-axis direction). Each of the first emission areas EA1 and the third emission areas EA3 may have a square planar shape, but embodiments are not limited thereto.

The non-display area NDA may include a first non-display area NDA1 and a second non-display area NDA2. The first non-display area NDA1 may be an area in which structures for driving pixels of the display area DA are disposed. The second non-display area NDA2 may be disposed outside the first non-display area NDA1. The second non-display area NDA2 may be an area outside the non-display area NDA. For example, the second non-display area NDA2 may be an area outside the display panel 100.

The first non-display area NDA1 may include a scan driving circuit unit SDC, a first power line VSL, a first dam DAM1, and a second dam DAM2.

The scan driving circuit unit SDC may include stages STA. The stages STA may be connected to scan lines of the display area DA extending in the first direction (e.g., X-axis direction), respectively. For example, the stages STA may be connected one-to-one to the scan lines of the display area DA extending in the first direction (e.g., X-axis direction). The stages STA may sequentially apply scan signals to the scan lines.

The first power line VSL may be disposed outside the scan driving circuit unit SDC. For example, the first power line VSL may be disposed closer to an edge portion EG of the display panel 100 than the scan driving circuit unit SDC. The first power line VSL may extend in the second direction (e.g., Y-axis direction) in the non-display area NDA on the left side of the display panel 100.

The first power line VSL may be electrically connected to the common electrode 173, so that the common electrode 173 may be supplied with the first source voltage from the first power line VSL.

The first dam DAM1 and the second dam DAM2 may be structures for preventing the overflow of the encapsulation organic layer TFE2 of the encapsulation layer ENC into the edge portion EG of the display panel 100.

The first dam DAM1 may be disposed to surround the display area DA, and the second dam DAM2 may be disposed to surround the first dam DAM1. For example, as illustrated in FIG. 6, the first dam DAM1 and the second dam DAM2 may extend in the second direction (e.g., Y-axis direction) in the non-display area NDA on the right side of the display panel 100. The second dam DAM2 may be disposed outside the first dam DAM1. For example, the first dam DAM1 and the second dam DAM2 may also be disposed in the non-display area NDA on the upper side, lower side, and left side of the display panel 100. The first dam DAM1 and the second dam DAM2 may extend in the second direction (e.g., Y-axis direction) in the non-display area NDA on the left side of the display panel 100, and may extend in the first direction (e.g., X-axis direction) in the non-display area NDA on the upper side and the lower side of the display panel 100.

The first dam DAM1 may be disposed closer to the scan driving circuit unit SDC than the second dam DAM2, and the second dam DAM2 may be disposed closer to the edge portion EG of the display panel 100 than the first dam DAM1.

Although FIG. 6 illustrates that the first dam DAM1 and the second dam DAM2 are disposed on the first power line VSL, embodiments are not limited thereto. For example, either one of the first dam DAM1 and the second dam DAM2 may not be disposed on the first power line VSL. In another example, neither the first dam DAM1 nor the second dam DAM2 may be disposed on the first power line VSL. For example, the first dam DAM1 and the second dam DAM2 may be disposed outside the first power line VSL.

For example, although FIG. 6 illustrates that the display panel 100 according to an embodiment includes two dams DAM1 and DAM2, embodiments are not limited thereto. For example, the display panel 100 according to an embodiment may include three or more dams.

The second non-display area NDA2 may include a crack dam CRD and an edge area EGA.

The crack dam CRD may be a structure for preventing cracks from propagating in a process of cutting the substrate SUB during the manufacturing process of the display device 10. For example, the crack dam CRD may be a structure for preventing crack propagation of inorganic layers of the encapsulation layer ENC.

The crack dam CRD may be disposed in the second non-display area NDA2 and may be disposed outside the first dam DAM1 and the second dam DAM2. For example, the crack dam CRD may be disposed closer to the edge portion EG of the display panel 100 than the first dam DAM1 and the second dam DAM2.

The crack dam CRD may be disposed along left, upper, and right edge portions of the display panel 100. For example, as illustrated in FIG. 6, the crack dam CRD may extend in the second direction (e.g., Y-axis direction) in the non-display area NDA on the right side of the display panel 100. For example, the crack dam CRD may also be disposed in the non-display area NDA on the upper side and the left side of the display panel 100. The crack dam CRD may extend in the second direction (e.g., Y-axis direction) in the non-display area NDA on the left side of the display panel 100, and may extend in the first direction (e.g., X-axis direction) in the non-display area NDA on the upper side of the display panel 100. The crack dam CRD may not be disposed on the lower edge portion of the display panel 100. However, embodiments are not limited thereto, and in another embodiment, the crack dam CRD may also be disposed in the non-display area NDA below the display panel 100. For example, the crack dam CRD may extend in the first direction (e.g., X-axis direction).

The edge area EGA may be disposed along the edge portion EG of the display panel 100. The edge area EGA may be an area in which processing traces generated in a process of cutting the substrate SUB are generated. For example, in the case that the substrate SUB is cut by spraying the etchant after laser irradiation by a laser processing device, the edge area EGA may be an area in which processing traces are formed on a top surface (or upper surface) US of the substrate SUB by the etchant. The width of the edge area EGA may be within about 30 µm, but embodiments are not limited thereto.

As shown in FIG. 7, the edge area EGA may include a first inclined surface IP1_1 formed by spraying the etchant after laser irradiation. An angle θ1 between a side surface SS1 and a top surface (or upper surface) US may be within about 90 degrees. For example, an angle between the side surface SS1 and the top surface (or upper surface) US may be substantially vertical. An angle θ2 between the side surface SS1 and the first inclined surface IP1_1 and an angle θ3 between the first inclined surface IP1_1 and a bottom surface (or lower surface) BS may be obtuse angles. The processing traces formed on the top surface (or upper surface) US of the substrate SUB may overlap the first inclined surface IP1_1 in the third direction (e.g., Z-axis direction).

However, embodiments are not limited thereto, and in some embodiments, the first inclined surface IP1_1 may be omitted. According to the manufacturing process of the display device 10, the first inclined surface IP1_1 may not be formed, and only the side surface SS1 may be disposed between the top surface (or upper surface) US and the bottom surface (or lower surface) BS. For example, the side surface SS1 may have a curved shape as well as a flat surface. Hereinafter, for simplicity of description, a case including the first inclined surface IP1_1 will be described as an example.

In the case that the substrate SUB of the display panel 100 is cut by spraying the etchant after the irradiation of the laser, the minimum distance D1 from the crack dam CRD to the edge portion EG of the display panel 100 may be reduced as compared to the case of performing a polishing process after cutting the substrate SUB with a cutting member. Accordingly, in the case that the substrate SUB of the display panel 100 is cut by spraying the etchant after laser irradiation, the width of the second non-display area NDA2 may be greatly reduced. For example, the width of the non-display area NDA may be minimized.

In the display device 10 according to an embodiment, the residue trace RSD may be disposed over the display area DA and the non-display area NDA. For example, the residue trace RSD may be disposed in the display area DA, the first non-display area NDA1, and the second non-display area NDA2.

In some embodiments, as illustrated in FIG. 6, the residue trace RSD may be disposed on the emission areas EA1, EA2, EA3, and EA4, the scan driving circuit unit SDC, the first power line VSL, the first dam DAM1, and the second dam DAM2. The residue trace RSD may overlap the emission areas EA1, EA2, EA3, and EA4, the scan driving circuit unit SDC, the first power line VSL, the first dam DAM1, and the second dam DAM2 in the third direction (e.g., Z-axis direction).

In some embodiments, as illustrated in FIG. 7, the residue trace RSD may not be disposed on the crack dam CRD, the edge area EGA, and the first inclined surface IP1_1. For example, the residue trace RSD may not overlap the crack dam CRD, the edge area EGA, and the first inclined surface IP1_1 in the third direction (e.g., Z-axis direction).

In some embodiments, as illustrated in FIG. 6, an outer boundary RSDa of the residue trace RSD may be disposed along the left, upper, right, and lower edge portions of the display panel 100. For example, the outer boundary RSDa of the residue trace RSD may be closer to the center portion of the display panel 100 than the left, upper, right, and lower edge portions of the display panel 100. For example, as illustrated in FIG. 6, the outer boundary RSDa of the residue trace RSD may extend in the second direction (e.g., Y-axis direction) in the non-display area NDA on the right side of the display panel 100. For example, the outer boundary RSDa of the residue trace RSD may extend in the second direction (e.g., Y-axis direction) in the non-display area NDA on the left side of the display panel 100, and may extend in the first direction (e.g., X-axis direction) in the non-display area NDA on the upper and lower sides of the display panel 100.

In some embodiments, the outer boundary RSDa of the residue trace RSD may be disposed inside the crack dam CRD. For example, the outer boundary RSDa of the residue trace RSD may be placed inside the crack dam CRD at the left, upper, right, and lower edge portions of the display panel 100. For example, the outer boundary RSDa of the residue trace RSD may be closer to the center portion of the display panel 100 than the crack dam CRD at the left, upper, right, and lower edge portions of the display panel 100.

In some embodiments, the display device 10 may include a residue area RA in which the residue trace RSD is disposed, and a non-residue area NRA in which the residue trace RSD is not disposed.

The residue area RA may be an area inside (or defined by) the outer boundary RSDa of the residue trace RSD. The non-residue area NRA may be an area outside the outer boundary RSDa of the residue trace RSD.

In some embodiments, the residue area RA may be disposed inside the edge area EGA in plan view. For example, as illustrated in FIG. 6, the residue area RA may be disposed on the other side of the edge area EGA in the first direction (e.g., X-axis direction) in the non-display area NDA on the right side of the display panel 100. For example, the residue area RA may be disposed on a side of the edge area EGA in the first direction (e.g., X-axis direction) in the non-display area NDA on the left side of the display panel 100, may be disposed on the other side of the edge area EGA in the second direction (e.g., Y-axis direction) in the non-display area NDA on the upper side of the display panel 100, and may be disposed on a side of the edge area EGA in the second direction (e.g., Y-axis direction) in the non-display area NDA on the lower side of the display panel 100.

FIG. 8 is an enlarged schematic view of area C of FIG. 7.

Referring to FIG. 8, the crack dam CRD and the first organic layer 160 may include the same material. The crack dam CRD may be disposed on the first buffer layer BF1. The crack dam CRD may be formed of an organic layer such as acryl resin, epoxy resin, phenolic resin, polyamide resin, polyimide resin and the like.

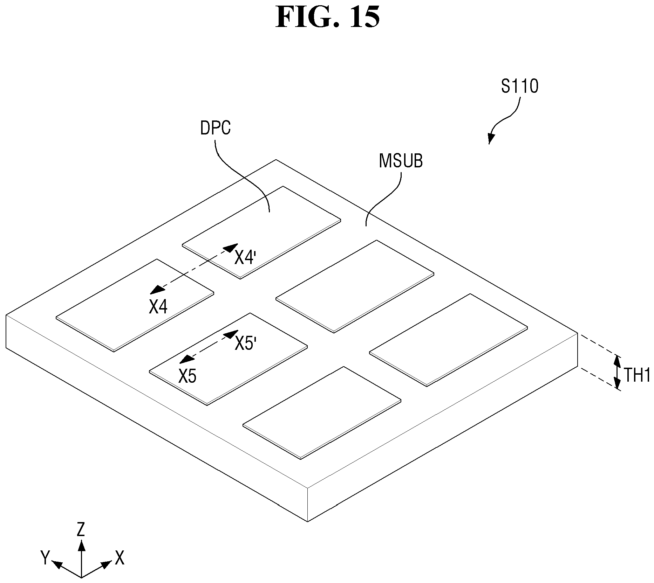

Although FIG. 8 illustrates that the crack dam CRD includes an organic film layer, embodiments are not limited thereto. For example, the crack dam CRD may further include another organic film layer. The another organic film layer of the crack dam CRD and the second organic layer 180 may include the same material. In another example, the crack dam CRD may further include another organic film layer. The another organic film layer of the crack dam CRD and the pixel defining layer 190 may include the same material. In another example, the crack dam CRD may further include another organic film layer. The another organic film layer of the crack dam CRD and the spacer 191 (see FIG. 15) may include the same material.

The first power line VSL and the first data metal layer including the first connection electrode CE1 and the data lines may include the same material. The first power line VSL and the first data metal layer including the first connection electrode CE1 and the data lines may be disposed on the same layer (at the same level). The first power line VSL may be disposed on the second interlayer insulating layer 142. The first power line VSL may be formed as a single layer or multiple layers made of any one of molybdenum (Mo), aluminium (Al), chromium (Cr), gold (Au), titanium (Ti), nickel (Ni), neodymium (Nd), and copper (Cu) or an alloy thereof.

The first dam DAM1 and the second dam DAM2 may be disposed on the first power line VSL. The first dam DAM1 may include a first sub-dam SDAM1 and a second sub-dam SDAM2, and the second dam DAM2 may include a first sub-dam SDAM1, a second sub-dam SDAM2, and a third sub-dam SDAM3. The first sub-dam SDAM1 and the first organic layer 160 may include the same material, and may be disposed on the same layer (at the same level). The second sub-dam SDAM2 and the second organic layer 180 may include the same material, and may be disposed on the same layer (at the same level). The third sub-dam SDAM3 and the pixel defining layer 190 may include the same material and may be disposed on the same layer (at the same level).

The height of the first dam DAM1 may be lower than the height of the second dam DAM2, but embodiments are not limited thereto. The height of the first dam DAM1 may be substantially the same as the height of the second dam DAM2 or may be higher than the height of the second dam DAM2.

The common electrode 173 may be connected to the first power line VSL exposed without being covered by the first organic layer 160, the second organic layer 180, and the first dam DAM1. Accordingly, the common electrode 173 may be supplied with the first source voltage of the first power line VSL.

The first encapsulation inorganic layer TFE1 may cover the first dam DAM1, the second dam DAM2, and the crack dam CRD in the non-display area NDA. In an embodiment, the first encapsulation inorganic layer TFE1 may extend adjacent to the edge portion EG of the display panel 100 in the non-display area NDA. The lateral side of the first encapsulation inorganic layer TFE1 may be disposed to be aligned with and coincident with the lateral side of the substrate SUB.

However, embodiments are not limited thereto, and in another embodiment, the first encapsulation inorganic layer TFE1 may not cover at least one of the second dam DAM2, or the crack dam CRD. For example, the first encapsulation inorganic layer TFE1 may not cover the crack dam CRD. In another example, an end portion of the first encapsulation inorganic layer TFE1 may be disposed inside the crack dam CRD. For example, the end portion of the first encapsulation inorganic layer TFE1 may be closer to the display panel 100 than the crack dam CRD.

The encapsulation organic layer TFE2 may be disposed to cover the top surface (or upper surface) of the first dam DAM1 without covering the top surface (or upper surface) of the second dam DAM2. However, embodiments are not limited thereto. The encapsulation organic layer TFE2 may not cover both the top surface (or upper surface) of the first dam DAM1 and the top surface (or upper surface) of the second dam DAM2. The encapsulation organic layer TFE2 may not overflow to the edge portion EG of the display panel 100 due to the first dam DAM1 and the second dam DAM2.

The second encapsulation inorganic layer TFE3 may cover the first dam DAM1, the second dam DAM2, and the crack dam CRD in the non-display area NDA. In an embodiment, the second encapsulation inorganic layer TFE3 may extend adjacent to the edge portion EG of the display panel 100 in the non-display area NDA. The lateral side of the second encapsulation inorganic layer TFE3 may be disposed to be aligned with and coincident with the lateral side of the substrate SUB.

However, embodiments are not limited thereto, and in another embodiment, the second encapsulation inorganic layer TFE3 may not cover at least one of the second dam DAM2, or the crack dam CRD. For example, the second encapsulation inorganic layer TFE3 may not cover the crack dam CRD. In another example, an end portion of the second encapsulation inorganic layer TFE3 may be disposed inside the crack dam CRD. For example, the end portion of the second encapsulation inorganic layer TFE3 may be closer to the center portion of the display panel 100 than the crack dam CRD.

An inorganic encapsulation area in which the first encapsulation inorganic layer TFE1 and the second encapsulation inorganic layer TFE3 are in contact with each other may be formed from the second dam DAM2 to the edge portion EG of the display panel 100. The inorganic encapsulation area may be disposed to surround the second dam DAM2.

In FIG. 8, a scan thin film transistor STFT of the scan driving circuit unit SDC may be an example. For example, the scan thin film transistor STFT may include a gate electrode STG, a channel region STCH, a source region STS, and a drain region STD. For example, the channel region STCH, the source region STS, and the drain region STD may be disposed on the first buffer layer BF1, and the gate electrode STG may overlap the channel region STCH in the third direction (e.g., Z-axis direction). Since the scan thin film transistor STFT is substantially the same as the thin film transistor TFT described in conjunction with FIG. 5, a description of the scan thin film transistor STFT will be omitted.

In the display device 10 according to an embodiment, the thickness of the residue trace RSD may be several nanometers to several tens of nanometers. In an embodiment, the residue trace RSD and the coating layer CTL (see FIG. 16) may include the same material in a manufacturing method (see FIG. 13) for a display device to be described later. In another embodiment, the residue trace RSD and the layer positioned under the residue trace RSD may include the same material. For example, the residue trace RSD and the second encapsulation inorganic layer TFE3 may include the same material. The residue trace RSD and the second sensor insulating layer TINS2 may include the same material.

As an example, the residue trace RSD may be formed as a part of the coating layer CTL (see FIG. 16) is left in the case that the coating layer CTL is removed. As another example, the residue trace RSD may be formed as a part of the layer positioned under the residue trace RSD is removed along with the coating layer CTL (see FIG. 16) in the case that the coating layer CTL is removed.

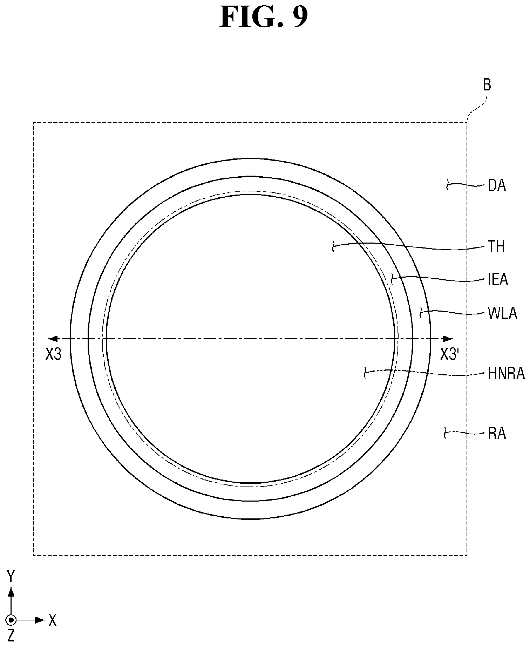

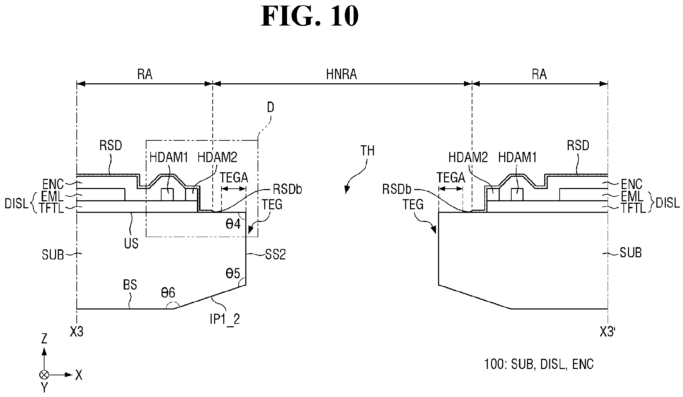

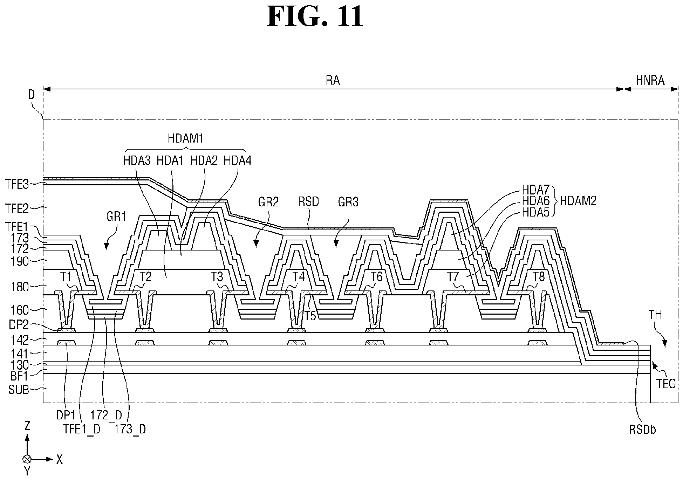

FIG. 9 is an enlarged schematic view of area B of FIG. 2. FIG. 10 is a schematic cross-sectional view taken along line X3-X3' of FIG. 9. FIG. 11 is an enlarged schematic view of area D of FIG. 10.

Referring to FIGS. 9 to 11, the display panel 100 according to an embodiment may include an inorganic encapsulation area IEA surrounding the through hole TH and a wiring area WLA surrounding the inorganic encapsulation area IEA.

The first encapsulation inorganic layer TFE1 and the second encapsulation inorganic layer TFE3 of the encapsulation layer ENC may be in contact with each other, so that the inorganic encapsulation area IEA may be a layer for preventing oxygen or moisture from permeating into the light emitting element layer EML of the display layer DISL due to the through hole TH.

The inorganic encapsulation area IEA may include at least one dam, at least one tip portion, and at least one groove. For example, as illustrated in FIG. 11, the inorganic encapsulation area IEA may include a first hole dam HDAM1, a second hole dam HDAM2, first to eighth tip portions T1 to T8, and first to third grooves GR1 to GR3.

The first tip portion T1 and the second tip portion T2 may be disposed closer to the wiring area WLA than the first hole dam HDAM1. The first tip portion T1 may be disposed closer to the wiring area WLA than the second tip portion T2. The second tip portion T2 may be disposed between the first tip portion T1 and the first hole dam HDAM1. At least a part of the second tip portion T2 may overlap the first hole dam HDAM1 in the third direction (e.g., Z-axis direction).

The third tip portion T3, the fourth tip portion T4, the fifth tip portion T5, and the sixth tip portion T6 may be disposed between the first hole dam HDAM1 and the second hole dam HDAM2. At least a part of the third tip portion T3 may overlap the first hole dam HDAM1 in the third direction (e.g., Z-axis direction).

The seventh tip portion T7 and the eighth tip portion T8 may be disposed closer to the through hole TH than the second hole dam HDAM2. At least a part of the seventh tip portion T7 may overlap the second hole dam HDAM2 in the third direction (e.g., Z-axis direction). The eighth tip portion T8 may be disposed between the second hole dam HDAM2 and the through hole TH.

The first groove GR1 may be disposed between the first tip portion T1 and the second tip portion T2. The second groove GR2 may be disposed between the third tip portion T3 and the fourth tip portion T4. The third groove GR3 may be disposed between the fifth tip portion T5 and the sixth tip portion T6.

The wiring area WLA may be an area in which bypass lines due to the through hole TH are disposed. Some of the bypass lines may be connected to data lines, and some others of the bypass lines may be connected to a second power line to which a second source voltage higher than the first source voltage is applied. Yet some others of the bypass lines may be connected to the scan lines. The wiring area WLA may be surrounded by the display area DA.

FIG. 10 illustrates a cross section of the edge portion TEG of the through hole TH formed in the case that the substrate SUB is cut by spraying the etchant after laser irradiation by the laser processing device in the manufacturing process of the display device 10.

As illustrated in FIG. 10, in the case that the substrate SUB is cut by spraying the etchant after laser irradiation by the laser processing device in the manufacturing process of the display device 10, a through hole edge area TEGA may be an area in which processing traces are formed on the top surface (or upper surface) US of the substrate SUB. A width of the through hole edge area TEGA may be within about 30 µm, but embodiments are not limited thereto.

The through hole edge area TEGA may include a second inclined surface IP1_2 formed by spraying the etchant after laser irradiation. An angle θ4 between a side surface SS2 of the edge portion TEG of the through hole TH and the top surface (or upper surface) US may be within about 90 degrees. For example, an angle between the side surface SS2 of the edge portion TEG of the through hole TH and the top surface (or upper surface) US may be substantially close to vertical. An angle θ5 between the side surface SS2 of the edge portion TEG of the through hole TH and the second inclined surface IP1_2 and an angle θ6 between the second inclined surface IP1_2 and the bottom surface (or lower surface) BS may be obtuse angles. The processing traces formed on the top surface (or upper surface) US of the substrate SUB may overlap the second inclined surface IP1_2 in the third direction (e.g., Z-axis direction).

The angle θ5 between the side surface SS2 of the edge portion TEG of the through hole TH and the second inclined surface IP1_2 and the angle θ6 between the second inclined surface IP1_2 and the bottom surface (or lower surface) BS may vary according to the depth of the laser irradiation area formed by the laser in the case that the substrate SUB of the display panel 100 is cut by spraying the etchant after laser irradiation. The depth of the laser irradiation area formed by the laser to perform cutting along the edge portion EG (see FIG. 7 or the like) of the display panel 100 may be different from the depth of the laser irradiation area formed by the laser to perform cutting along the edge portion TEG of the through hole TH.

For example, the angle θ5 between the side surface SS2 of the edge portion TEG of the through hole TH illustrated in FIG. 10 and the second inclined surface IP1 _2 may be smaller than the angle θ2 between the side surface SS1 and the first inclined surface IP1_1 illustrated in FIG. 7. The angle θ6 between the second inclined surface IP1_2 and the bottom surface (or lower surface) BS illustrated in FIG. 10 may be greater than the angle θ3 between the first inclined surface IP1_1 and the bottom surface (or lower surface) BS illustrated in FIG. 7.

As illustrated in FIG. 11, a first dummy pattern DP1 and the second gate metal layer including the second capacitor electrode CAE2 of the capacitor Cst may include the same material and may be disposed on the same layer (at the same level). For example, the first dummy pattern DP1 may be disposed on the first interlayer insulating layer 141. The first dummy pattern DP1 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

A second dummy pattern DP2 and the first data metal layer including the first connection electrode CE1 and the data lines may include the same material and may be disposed on the same layer (at the same level). For example, the second dummy pattern DP2 may be disposed on the second interlayer insulating layer 142. The second dummy pattern DP2 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

The second dummy pattern DP2 may overlap the first dummy pattern DP1 in the third direction (e.g., Z-axis direction).

The first to eighth tip portions T1 to T8 and the second data metal layer including the second connection electrode CE2 may include the same material and may be disposed on the same layer (at the same level). For example, the first to eighth tip portions T1 to T8 may be disposed on the first organic layer 160. The first to eighth tip portions T1 to T8 may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof.

Each of the first to eighth tip portions T1 to T8 may be connected to the second dummy pattern DP2 through a contact hole penetrating the first organic layer 160. Each of the first to eighth tip portions T1 to T8 may include an eaves structure in which the top surface (or upper surface) and the bottom surface (or lower surface) are exposed without being covered by the first organic layer 160, the second organic layer 180, the first hole dam HDAM1, and the second hole dam HDAM2. The fourth tip portion T4 and the fifth tip portion T5 may be integral with each other. Each of the first to eighth tip portions T1 to T8 may be a protruding pattern or a trench pattern for forming a groove (or trench).

The through hole edge area TEGA may be disposed between the eighth tip portion T8 and the edge portion TEG of the through hole TH.

The first groove GR1 may be formed between the first tip portion T1 and the second tip portion T2, the second groove GR2 may be formed between the third tip portion T3 and the fourth tip portion T4, and the third groove GR3 may be formed between the fifth tip portion T5 and the sixth tip portion T6. The first groove GR1 may have an eaves structure formed by the first tip portion T1 and the second tip portion T2, the second groove GR2 may have an eaves structure formed by the third tip portion T3 and the fourth tip portion T4, and the third groove GR3 may have an eaves structure formed by the fifth tip portion T5 and the sixth tip portion T6.

Since the light emitting layer 172 is deposited by evaporation and the common electrode 173 is deposited by sputtering, the light emitting layer 172 and the common electrode 173 may be disposed to be broken at each of the first to third grooves GR1, GR2, and GR3 because the step coverage is low. For example, the first encapsulation inorganic layer TFE1 and the second encapsulation inorganic layer TFE3 may be deposited by chemical vapor deposition, atomic layer deposition, or the like, and thus may be formed to be continuous without being broken in each of the first to third grooves GR1, GR2, and GR3 because the step coverage is high. Step coverage refers to the ratio of the degree of thin film coated on an inclined portion to the degree of thin film coated on a flat portion. A broken light emitting layer remnant (or broken light emitting layer residue) 172_D and a broken common electrode remnant (or broken common electrode residue) 173_D may be disposed in the first to third grooves GR1, GR2, and GR3, respectively. For example, a part TEF1_D of the first encapsulation inorganic layer TFE1 may be disposed in the first to third grooves GR1, GR2, and GR3.

The first hole dam HDAM1 may include first to fourth hole sub-dams HDA1, HDA2, HDA3, and HDA4. The first hole sub-dam HDA1 may be disposed on the first organic layer 160. The first hole sub-dam HDA1 and the second organic layer 180 may include the same material. The first hole sub-dam HDA1 may be disposed on the second tip portion T2 and the third tip portion T3. The second hole sub-dam HDA2 may be disposed on the first hole sub-dam HDA1. The second hole sub-dam HDA2 and the pixel defining layer 190 may include the same material. The third hole sub-dam HDA3 and the fourth hole sub-dam HDA4 may be disposed on the second hole sub-dam HDA2. The third hole sub-dam HDA3, the fourth hole sub-dam HDA4, and the spacer 191 may include the same material, but embodiments are not limited thereto. The fourth hole sub-dam HDA4 may be disposed closer to the through hole TH than the third hole sub-dam HDA3. The thickness of the fourth hole sub-dam HDA4 may be greater than the thickness of the third hole sub-dam HDA3.

The second hole dam HDAM2 may include fifth to seventh hole sub-dams HDA5, HDA6, and HDA7. The fifth hole sub-dam HDA5 may be disposed on the first organic layer 160. The fifth hole sub-dam HDA5 and the second organic layer 180 may include the same material. The fifth hole sub-dam HDA5 may be disposed on the seventh tip portion T7. The sixth hole sub-dam HDA6 may be disposed on the fifth hole sub-dam HDA5. The sixth hole sub-dam HDA6 and the pixel defining layer 190 may include the same material. The seventh hole sub-dam HDA7 may be disposed on the sixth hole sub-dam HDA6. The seventh hole sub-dam HDA7 and the spacer 191 may include the same material, but embodiments are not limited thereto.

The overflow of the encapsulation organic layer TFE2 into the through hole TH may be prevented by the first hole dam HDAM1 and the second hole dam HDAM2.

The broken light emitting layer remnant 172_D, the broken common electrode remnant 173_D, the first encapsulation inorganic layer TFE1, and the second encapsulation inorganic layer TFE3 may extend to the edge portion TEG of the through hole TH. The end portion of the broken light emitting layer remnant 172_D, the end portion of the broken common electrode remnant 173_D, the end portion of the first encapsulation inorganic layer TFE1, or the end portion of the second encapsulation inorganic layer TFE3 may coincide with the edge portion TEG of the through hole TH. However, embodiments are not limited thereto, and the end portion of the broken light emitting layer remnant 172_D, the end portion of the broken common electrode remnant 173_D, the end portion of the first encapsulation inorganic layer TFE1, or the end portion of the second encapsulation inorganic layer TFE3 may not coincide with the edge portion TEG of the through hole TH.

As illustrated in FIG. 11, since the light emitting layer 172 and the common electrode 173 are broken in the first to third grooves GR1, GR2, and GR3 formed by the first to eighth tip portions T1 to T8, respectively, it is possible to protect the light emitting layer 172 and the common electrode 173 exposed through the through hole TH from the permeation of oxygen, moisture, or the like through the through hole TH.

In some embodiments, as illustrated in FIG. 9, the display device 10 according to an embodiment may include the residue area RA and a hole non-residue area HNRA.

The residue area RA may be an area in which the residue trace RSD is disposed. The residue area RA may overlap the inorganic encapsulation area IEA and the wiring area WLA in the third direction (e.g., Z-axis direction). The residue area RA may surround the through hole TH in plan view. The residue area RA may not overlap the through hole TH in the third direction (e.g., Z-axis direction).

The hole non-residue area HNRA may be an area in which the residue trace RSD is not disposed. For example, the hole non-residue area HNRA may be surrounded by the residue area RA. The hole non-residue area HNRA may be an area in which an opening OP (see FIG. 16) of the coating layer CTL (see FIG. 16) is disposed.

The hole non-residue area HNRA may overlap the through hole TH in the third direction (e.g., Z-axis direction). At least a part of the hole non-residue area HNRA may overlap the through hole edge area TEGA in the third direction (e.g., Z-axis direction). In an embodiment, the hole non-residue area HNRA may be disposed inside the first hole dam HDAM1 and the second hole dam HDAM2.

In some embodiments, the shape of the hole non-residue area HNRA may conform to (or align with) the shape of the through hole TH. For example, in the case that the through hole TH is of a circular shape, the hole non-residue area HNRA may also have a circular shape. However, embodiments are not limited thereto.

In some embodiments, the hole non-residue area HNRA may be larger than the through hole TH in plan view. For example, in plan view, the area (or size) of the hole non-residue area HNRA may be larger than the area (or size) of the through hole TH. However, embodiments are not limited thereto, and the size of the hole non-residue area HNRA may be equal to the size of the through hole TH.

In some embodiments, the residue trace RSD may not overlap the through hole TH. For example, the residue trace RSD may not overlap the through hole TH due to the opening OP (see FIG. 16) of the coating layer CTL (see FIG. 16) surrounding the through hole TH. The residue trace RSD may be disposed on the first to eighth tip portions T1 to T8, the first hole dam HDAM1, and the second hole dam HDAM2.

In some embodiments, an inner boundary RSDb of the residue trace RSD may surround the through hole TH. The inner boundary RSDb of the residue trace RSD may be a boundary between the residue area RA and the hole non-residue area HNRA. For example, the inner boundary RSDb of the residue trace RSD may be disposed outside the circumference of the through hole TH in plan view. The inner boundary RSDb of the residue trace RSD may be disposed outside the edge portion TEG of the through hole TH. However, embodiments are not limited thereto, and the inner boundary RSDb of the residue trace RSD may coincide with the circumference of the through hole TH in the third direction (e.g., Z-axis direction).

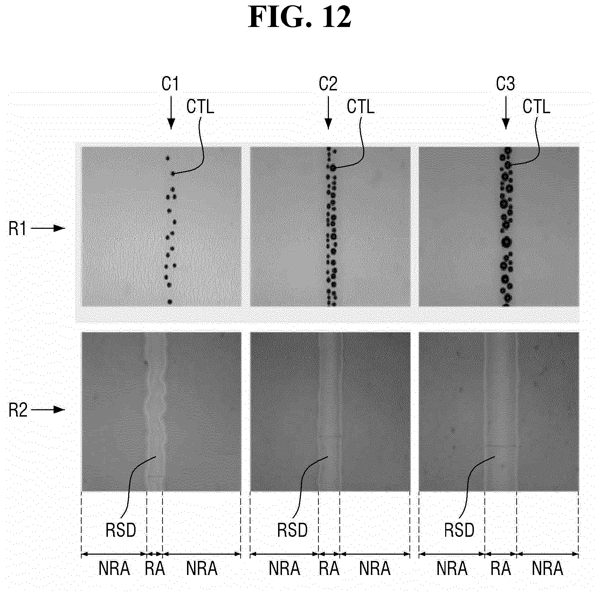

FIG. 12 is a series of photographs illustrating a process through which a residue trace of a display device 10 according to an embodiment is formed.

Referring to FIG. 12, the residue trace RSD may be formed as the coating layer CTL is removed in the manufacturing method S1 (see FIG. 13) for a display device 10 to be described later. The coating layer CTL may be formed by a printing process such as inkjet.

The photographs disposed in a first row R1 illustrate a state immediately after ink, which is a material of the coating layer CTL, is deposited on an arbitrary inorganic layer such as the second sensor insulating layer TINS2 or the second encapsulating inorganic layer TFE3. The photographs disposed in a second row R2 show a state of the arbitrary inorganic layer after the coating layer CTL is removed.

The shape of the residue trace of FIG. 12 is an example, and the shape of the residue trace RSD is not limited to the shape shown in the drawing.

In the first row R1, the photographs disposed in a first column C1, a second column C2, and a third column C3 show states in which the ink is coated in different densities and different amounts according to the width and the thickness of the coating layer CTL. For example, the coating layer CTL of the first column C1 may have a width and a thickness smaller than a width and a thickness of the coating layer CTL of the second column C2, and the coating layer CTL of the second column C2 may have a width and a thickness smaller than a width and a thickness of the coating layer CTL of the third column C3.

In the second row R2, the photographs disposed in the first column C1, the second column C2, and the third column C3 respectively show the residue traces RSD formed as the coating layers CTL of the first column C1, the second column C2, and the third column C3 are removed. For example, the residue trace RSD in the first column C1 of the second row R2 may be formed as the coating layer CTL in the first column C1 of the first row R1 is removed, the residue trace RSD in the second column C2 of the second row R2 may be formed as the coating layer CTL in the second column C2 of the first row R1 is removed, and the residue trace RSD in the third column C3 of the second row R2 may be formed as the coating layer CTL in the third column C3 of the first row R1 is removed.

The photographs in the first row R1 may be taken through an optical microscope, and the photographs in the second row R2 may be taken through a scanning electron microscope (SEM).

As illustrated in the drawing, the light transmittance of the residue area RA in which the residue trace RSD is disposed may be different from the light transmittance of the non-residue area NRA in which the residue trace RSD is not disposed. As an example, the light transmittance of the residue area RA in which the residue trace RSD is disposed may be lower than the light transmittance of the non-residue area NRA in which the residue trace RSD is not disposed, but embodiments are not limited thereto.

Since the description of the non-residue area NRA may be applied to the hole non-residue area HNRA (see FIG. 9), a detailed description thereof will be omitted.

Hereinafter, a method of manufacturing a display device 10 according to an embodiment will be described.

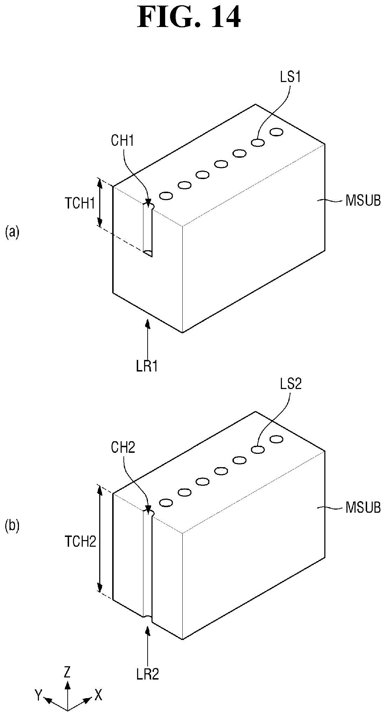

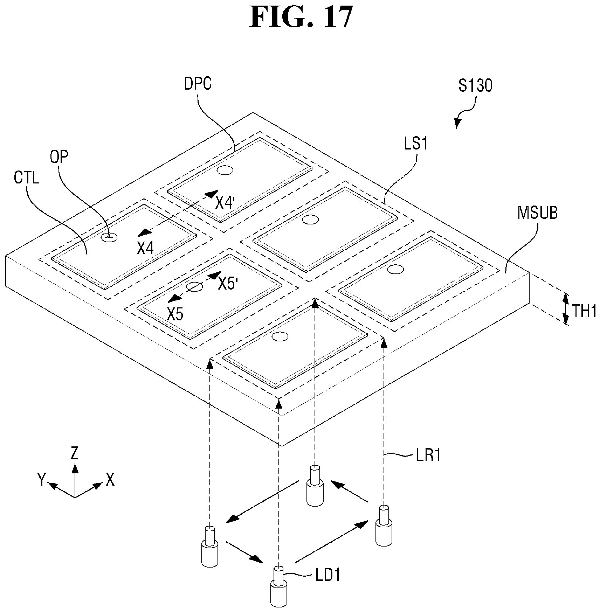

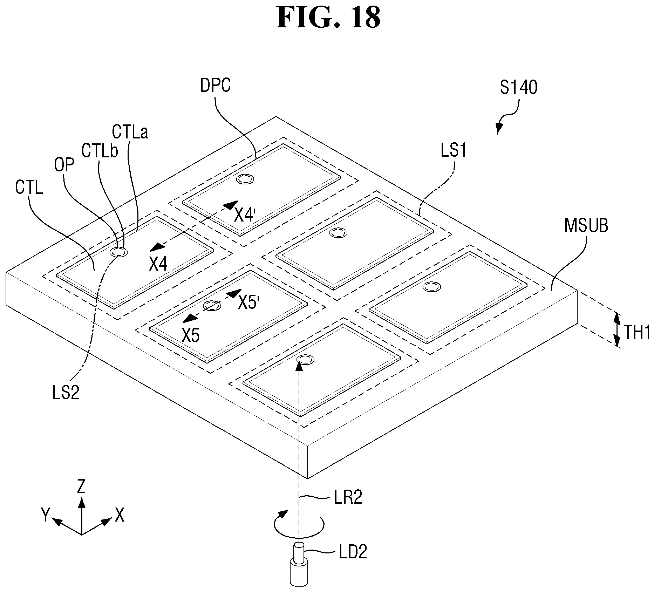

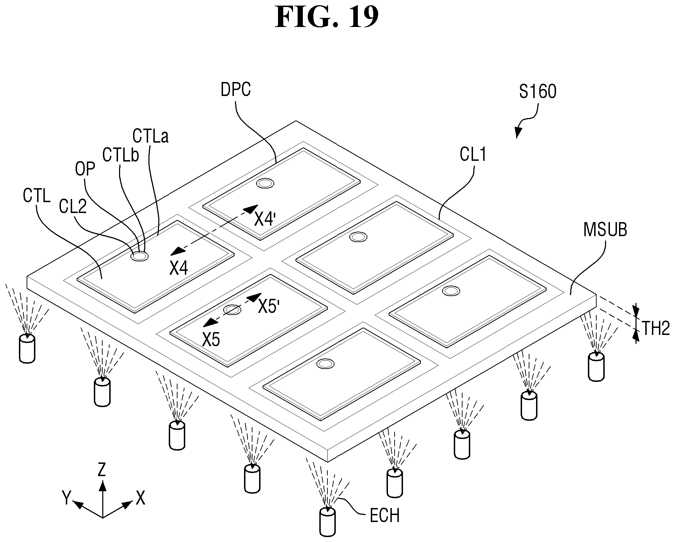

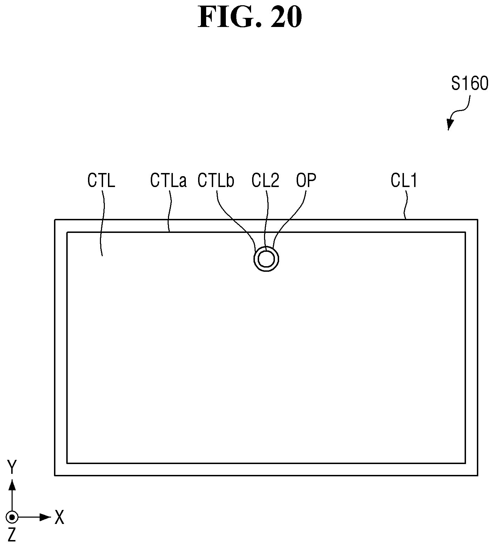

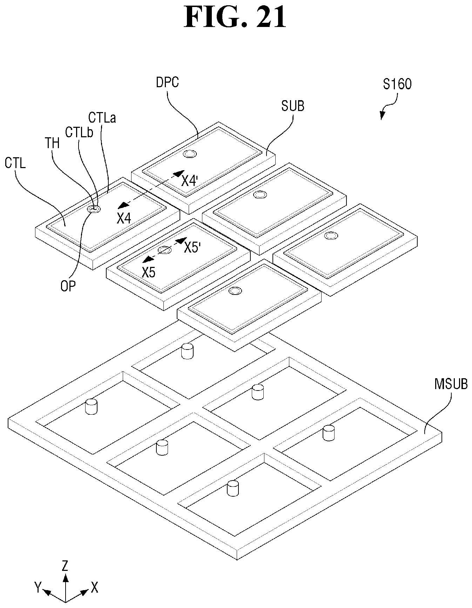

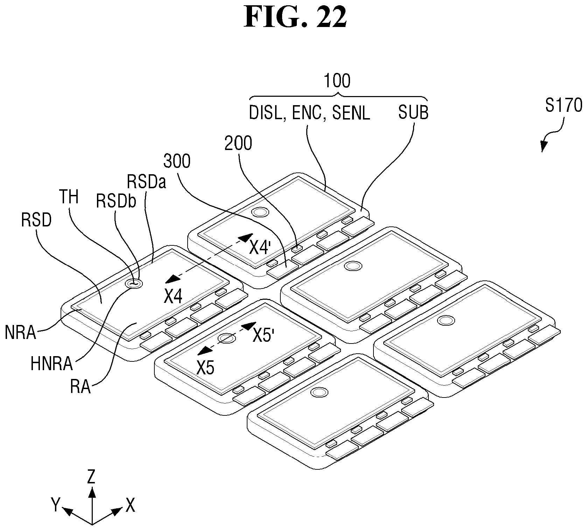

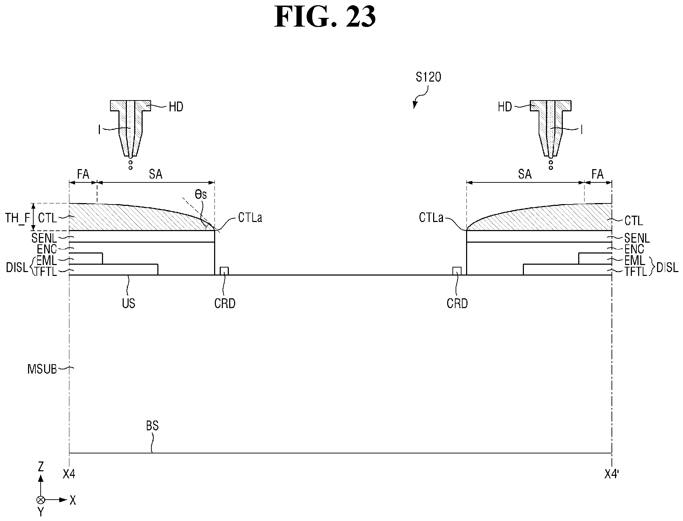

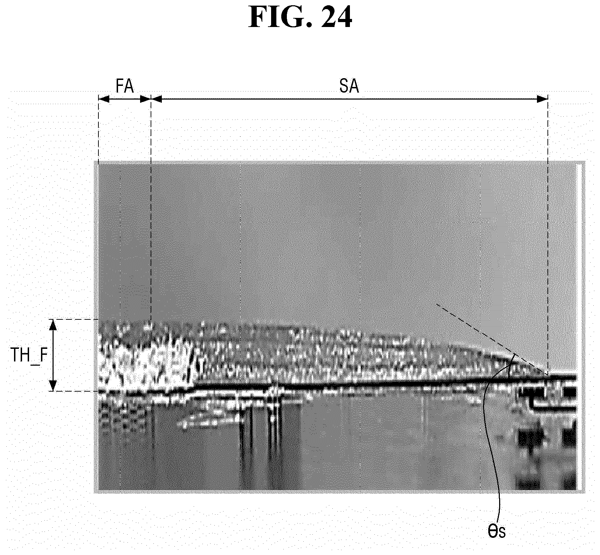

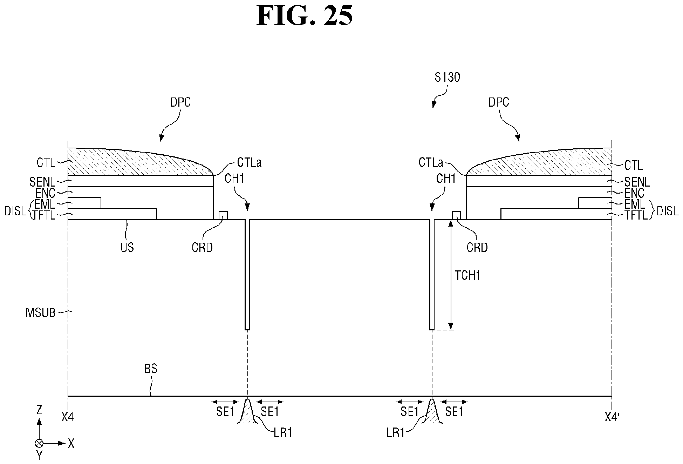

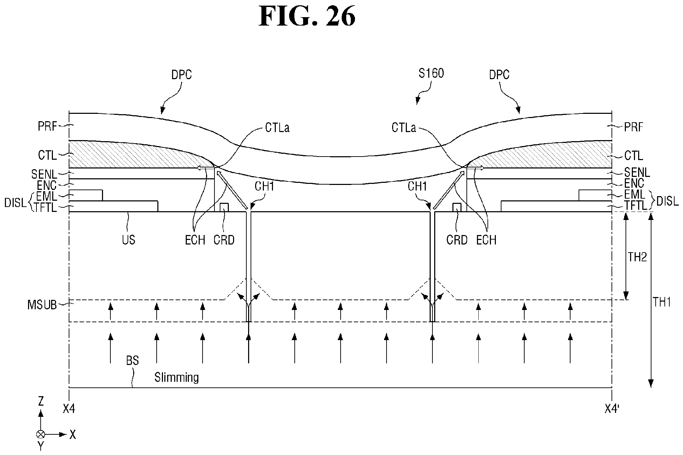

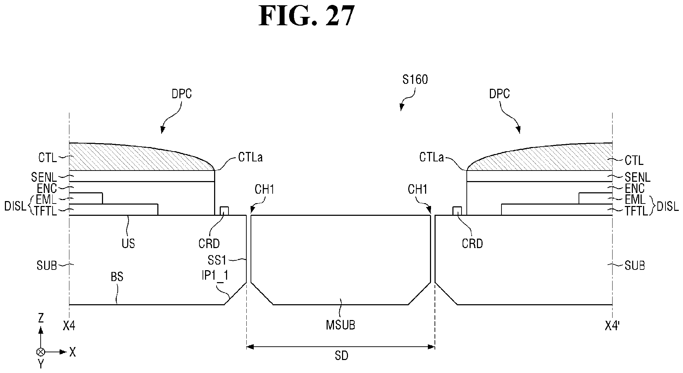

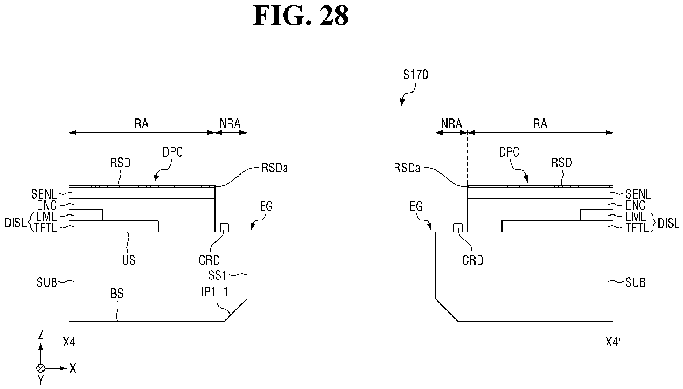

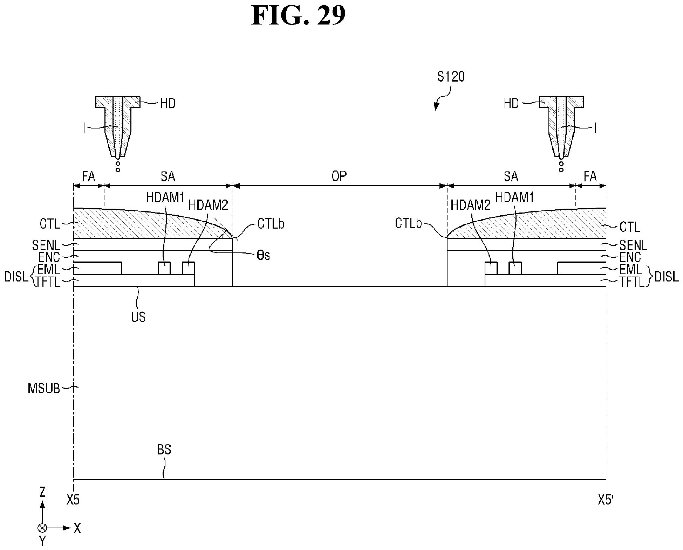

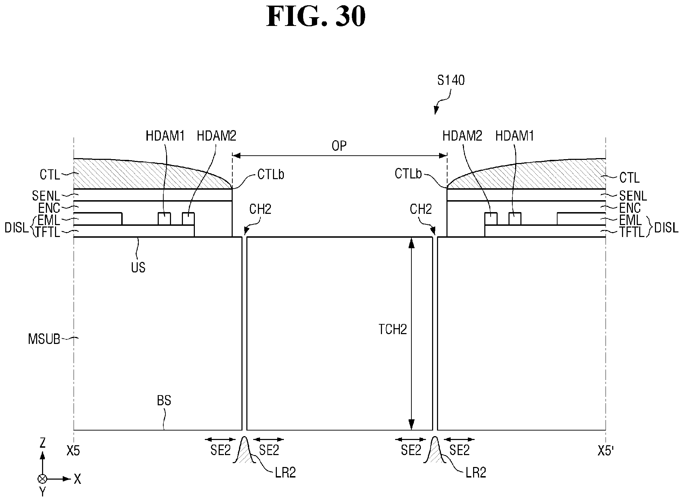

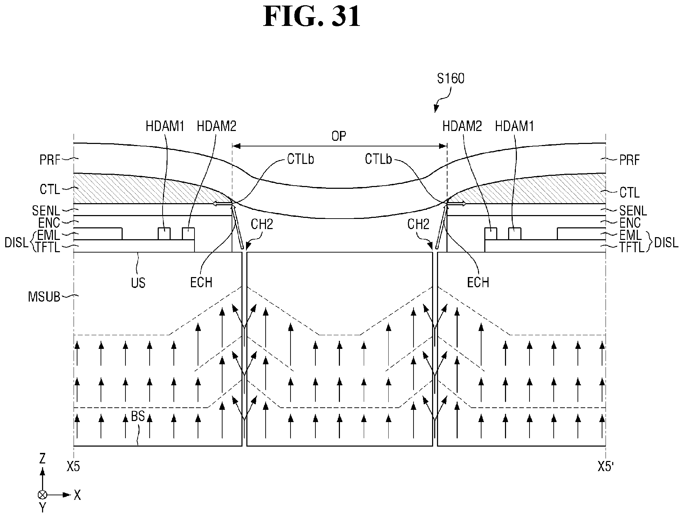

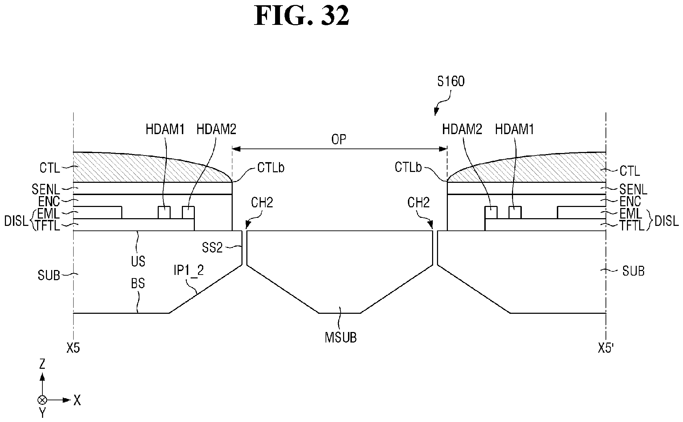

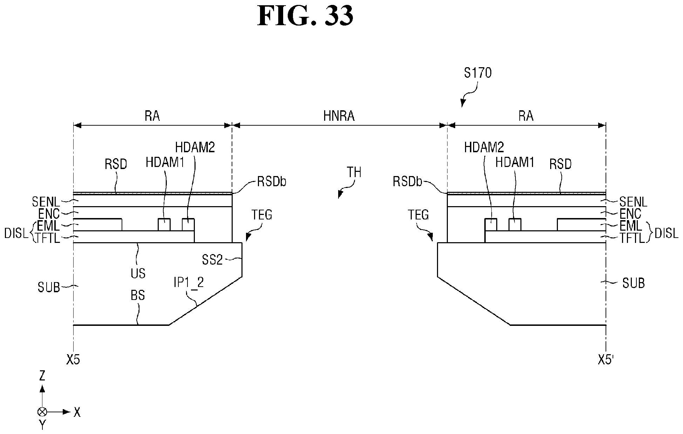

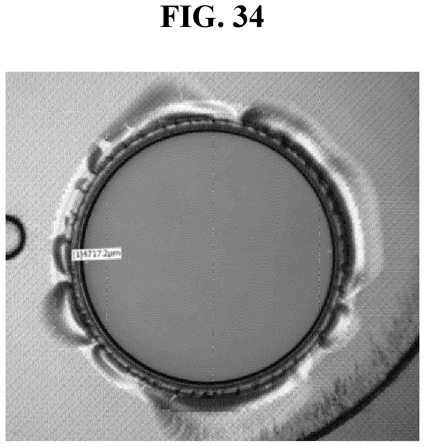

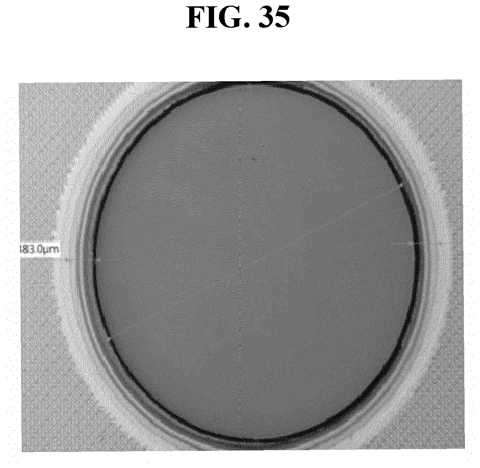

FIG. 13 is a flowchart showing a method of manufacturing a display device 10 according to an embodiment. FIG. 14 is a schematic diagram illustrating the depth of a laser irradiation area formed by a laser processing device according to an embodiment. FIG. 15 is a schematic perspective view showing step S110 of FIG. 13. FIG. 16 is a schematic perspective view showing step S120 of FIG. 13. FIG. 17 is a schematic perspective view showing step S130 of FIG. 13. FIG. 18 is a schematic perspective view showing step S140 of FIG. 13. FIG. 19 is a schematic perspective view showing step S160 of FIG. 13. FIG. 20 is a schematic plan view showing step S160 of FIG. 13. FIG. 21 is a schematic perspective view showing step S160 of FIG. 13. FIG. 22 is a schematic perspective view showing step S170 of FIG. 13. FIG. 23 is a schematic cross-sectional view showing step S120 of FIG. 13. FIG. 24 is a schematic cross-sectional view showing a coating layer according to an embodiment. FIG. 25 is a schematic cross-sectional view showing step S130 of FIG. 13. FIG. 26 is a schematic cross-sectional view showing step S160 of FIG. 13. FIG. 27 is a schematic cross-sectional view showing step S160 of FIG. 13. FIG. 28 is a schematic cross-sectional view showing step S170 of FIG. 13. FIG. 29 is a cross-sectional view showing step S120 of FIG. 13. FIG. 30 is a schematic cross-sectional view showing step S140 of FIG. 13. FIG. 31 is a schematic cross-sectional view showing step S160 of FIG. 13. FIG. 32 is a schematic cross-sectional view showing step S160 of FIG. 13. FIG. 33 is a schematic cross-sectional view showing step S170 of FIG. 13. FIG. 34 is a photograph showing a through hole and the vicinity thereof according to a comparative example. FIG. 35 is a photograph showing a through hole and the vicinity thereof according to an embodiment.

Referring to FIGS. 13 to 33, in the manufacturing method S1 for a display device 10 according to an embodiment, display cells DPC may be formed on a first surface of a mother substrate MSUB (step S110 in FIG. 13).

As shown in FIGS. 16, 23, 24, and 29, the coating layer CTL may be formed on the display cells DPC, and the display cells DPC may be inspected (step S120 in FIG. 13).

For example, the coating layer CTL may be formed to cover the display cells DPC.

As shown in FIG. 16, the coating layer CTL may be disposed on the display cell DPC. The coating layer CTL may cover the top surface (or upper surface) of the display cell DPC. The coating layer CTL may include the opening OP exposing at least a part of the display cell DPC. In an embodiment, the coating layer CTL may be smaller than the display cell DPC in plan view, but embodiments are not limited thereto.

An outer boundary CTLa of the coating layer CTL may be disposed adjacent to the perimeter of the display cell DPC. The shape of the outer boundary CTLa of the coating layer CTL may conform to (or align with) the shape of the perimeter of the display cell DPC. In an embodiment, the outer boundary CTLa of the coating layer CTL may be positioned inside the perimeter of the display cell DPC. For example, the outer boundary CTLa of the coating layer CTL may be closer to the center portion of the display cell DPC than the perimeter of the display cell DPC, but embodiments are not limited thereto.

An inner boundary CTLb of the coating layer CTL may be the circumference of the opening OP of the coating layer CTL. The shape of the inner boundary CTLb of the coating layer CTL may conform to (or align with) the shape of the opening OP. The shape of the inner boundary CTLb of the coating layer CTL may conform to (or align with) the shape of the through hole TH to be described later. In an embodiment, the inner boundary CTLb of the coating layer CTL may be positioned outside the through hole TH, but embodiments are not limited thereto.

In some embodiments, the coating layer CTL may be formed by an inkjet printing process. For example, the coating layer CTL may be formed by curing ink I coated on the display cell DPC by an inkjet head HD. However, embodiments are not limited thereto, and the coating layer CTL may be formed by a coating process such as screen printing or dispenser. The coating layer CTL may be cured by at least one of ultraviolet curing, thermal curing, and natural curing.

In an embodiment, the coating layer CTL may include acrylic resin, but embodiments are not limited thereto. For example, the coating layer CTL may be formed by curing the ink I including acrylic resin, but embodiments are not limited thereto.

In some embodiments, the coating layer CTL may include a material having acid resistance to protect the display cell DPC in an etching process to be described later. For example, the coating layer CTL may include at least one of epoxy resin and urethane resin. The coating layer CTL may selectively include at least one of acrylic resin, epoxy resin, and urethane resin.

As shown in FIGS. 23, 24, and 29, the coating layer CTL may include a flat portion FA and an inclined portion SA.

The flat portion FA may occupy most of the area of the coating layer CTL. The top surface (or upper surface) of the coating layer CTL may be flat in the flat portion FA. The thickness of the coating layer CTL in the flat portion FA may be substantially constant. For example, the thickness of the coating layer CTL being constant means that a difference in the thickness of the coating layer CTL is about ±6% of an average thickness. For example, a difference between a thickness TH_F of the flat portion FA and the average thickness of the coating layer CTL may be within about 6% of the average thickness of the coating layer CTL. In an embodiment, the average thickness of the coating layer CTL may be in the range of about 40 µm to about 150 µm, but embodiments are not limited thereto.

The inclined portion SA may be disposed adjacent to the perimeter of the display cell DPC and the opening OP of the coating layer CTL. In the inclined portion SA, the top surface (or upper surface) of the coating layer CTL may be an inclined surface. The inclined surface may be of a curved shape in cross-sectional view, but embodiments are not limited thereto, and may be linear.

In the inclined portion SA, the thickness of the coating layer CTL may decrease as it approaches the perimeter of the display cell DPC, and may decrease as it approaches the opening OP of the coating layer CTL. In the inclined portion SA, the thickness of the coating layer CTL may increase as it approaches the flat portion FA.

An angle θs of the tangent line of the inclined portion SA at the outer boundary CTLa and the inner boundary CTLb of the coating layer CTL may be within about 30 degrees. For example, the angle θs of the tangent line of the inclined portion SA at the outer boundary CTLa and the inner boundary CTLb of the coating layer CTL may be within about 15 degrees.

Since the manufacturing method S1 for a display device 10 according to an embodiment includes the step of forming the coating layer CTL, the process efficiency and the process yield may be improved.

The comparative example may include a cutting process of attaching a protective film on the entire surface of the mother substrate MSUB instead of the coating layer CTL and removing a part of the protective film according to the size of the display cell DPC. For example, the comparative example may include a cutting process of removing a part of the protective film to form an opening such as the opening OP of the coating layer CTL. As shown in FIG. 34, a laser process may be used to remove a part of the protective film. However, as an adhesive of the protective film is carbonized by laser, a carbonized foreign material may be generated at the cut portion, which causes poor adhesion of a layer thereunder. In an etching process to be described later, an etchant may permeate between the layers that are attached poorly, which causes corrosion and damage of the display cell DPC.

In the manufacturing method S1 for the display device 10 according to an embodiment, since the coating layer CTL having a required shape may be formed by a printing process, the cutting process as in the comparative example may be omitted. Therefore, as shown in FIG. 35, problems such as carbonized foreign matter, poor adhesion of a layer, and etchant permeation may not occur, so the process efficiency and the process yield may be improved.

After forming the coating layer CTL, the display cells DPC may be inspected using an inspection device. After connecting a probe to test pads provided on each of the display cells DPC, a lighting test of each of the display cells DPC may be performed.

In the case that the lighting test is performed after separating the display cells DPC from the mother substrate MSUB by the cutting process, an additional process for removing the test pads may be required after completing the lighting test. In the case that the lighting test is performed on the mother substrate MSUB, the test pads may be removed in the case that the display cells DPC are separated from the mother substrate MSUB through laser irradiation and etching later. Accordingly, in the case that the lighting test is performed on the mother substrate MSUB, there is an advantage in that no additional process for removing the test pads is required.

As illustrated in FIGS. 17 and 25, first laser irradiation areas CH1 disposed along the edge portions of the display cells DPC may be formed by irradiating a first laser LR1 on the second surface that faces the first surface of the mother substrate MSUB (step S130 in FIG. 13).

Although various types of lasers may be used as the first laser LR1 according to an embodiment, the first laser LR1 may be an infrared Bessel beam having a wavelength of about 1030 nm.

As illustrated in FIGS. 17 and 25, the first laser LR1 may be irradiated on the second surface of the mother substrate MSUB. However, embodiments are not limited thereto. The first laser LR1 may be irradiated on the first surface of the mother substrate MSUB.

A first sketch line LS1 may be defined as an imaginary line connecting the first laser irradiation areas CH1. The first sketch line LS1 may be formed by irradiating the first laser LR1 to form the first laser irradiation areas CH1 along edge portions of the display cells DPC.

A one-side tolerance SE1 of the first laser LR1 may be within about 50 µm, and the both-sides tolerance of the first laser LR1 may be within about 100 µm. The one-side tolerance SE1 of the first laser LR1 may be a cutting error in a direction (e.g., the X-axis direction) in the case that the first laser irradiation areas CH1 are formed by the first laser LR1.

As illustrated in FIGS. 18 and 30, second laser irradiation areas CH2 for forming the through hole TH in each of display cells may be formed by irradiating a second laser LR2 on the second surface of the mother substrate MSUB (step S140 in FIG. 13).

Although FIG. 13 illustrates that the step S140 is performed after the step S130 is performed, embodiments are not limited thereto. In order to reduce the process time, the step S130 and the step S140 may be performed simultaneously by providing laser processing devices LD1 and LD2. In another example, the step S130 may be performed after the step S140.

Although various types of lasers may be used as the second laser LR2 according to an embodiment, the second laser LR2 may be an infrared Bessel beam having a wavelength of about 1030 nm.

As illustrated in FIGS. 18 and 30, the second laser LR2 may be irradiated on the second surface of the mother substrate MSUB. However, embodiments are not limited thereto. The second laser LR2 may be irradiated on the first surface of the mother substrate MSUB.

A second sketch line LS2 may be defined as an imaginary line connecting the second laser irradiation areas CH2. The second sketch line LS2 may be formed by irradiating the second laser LR2 to form the second laser irradiation areas CH2 along the edge portion of the through hole TH. The second sketch line LS2 may depend on (or align with) the shape of the through hole. For example, in the case that the through hole TH has a circular planar shape, the second sketch line LS2 may be formed in a circular shape.

A one-side tolerance SE2 of the second laser LR2 may be within about 50 µm, and the both-sides tolerance of the second laser LR2 may be within about 100 µm. The one-side tolerance SE2 of the second laser LR2 may be a cutting error in a direction (e.g., the X-axis direction) in the case that the second laser irradiation areas CH2 are formed by the second laser LR2.

In the case that the first laser LR1 and the second laser LR2 are irradiated on the second surface of the mother substrate MSUB, as illustrated in FIG. 14, a depth TCH1 (or a sketch length) of each of the first laser irradiation areas CH1 and a depth TCH2 (or a sketch length) of each of the second laser irradiation areas CH2 may be adjusted according to a repetition rate, a processing speed, and pulse energy.

For example, the depth TCH1 of each of the first laser irradiation areas CH1 may be about 50 µm from the first surface of the mother substrate MSUB as illustrated in FIG. 14A. For example, since the thickness of the mother substrate MSUB may be about 500 µm, the depth TCH2 of each of the second laser irradiation areas CH2 may be about 500 µm. For example, the depth TCH2 of each of the second laser irradiation areas CH2 may be about 50 µm to about 500 µm from the first surface of the mother substrate MSUB.

The first laser LR1 for forming the first laser irradiation areas CH1 may be irradiated with a repetition rate of about 10 kHz to about 250 kHz, a processing speed of about 10 mm/s to about 250 mm/s, and pulse energy of about 10 µJ to about 300 µJ. However, in order for the first laser LR1 to have a depth of about 225 µm from the first surface of the mother substrate MSUB, the conditions of irradiation may include a repetition rate of about 17.5 kHz to about 125 kHz, a processing speed of about 17.5 mm/s to about 125 mm/s, and pulse energy of about 25 µJ to about 178 µJ.

The second laser LR2 for forming the second laser irradiation areas CH2 may be irradiated with a repetition rate of about 1 kHz to about 50 kHz, a processing speed of about 1 mm/s to about 50 mm/s, and pulse energy of about 10 µJ to about 300 µJ. However, in order for the second laser LR2 to have a depth of about 400 µm to about 500 µm from the first surface of the mother substrate MSUB, irradiation may be performed with a repetition rate of about 10 kHz, a processing speed of about 10 mm/s, and pulse energy of about 60 µJ to about 178 µJ. For example, while the second laser LR2 forms the circular second sketch line LS2, the first laser LR1 may form the first sketch line LS1 along the edge portion of each of the display cells DPC. Thus, the processing speed of the second laser LR2 may be smaller than the processing speed of the first laser LR1.

As shown in FIGS. 26 and 31, a protective film PRF may be attached on the coating layer CTL (step S150 in FIG. 13).

The protective film PRF may be attached on the entire first surface of the mother substrate MSUB. For example, the protective film PRF may be attached on the coating layer CTL and the mother substrate MSUB that is exposed without being covered by the coating layer CTL. The protective film PRF may cover the first laser irradiation areas CH1 and the second laser irradiation areas CH2.

The protective film PRF may be an acid-resistant film to protect the display cells DPC from an etchant in an etching process for the mother substrate MSUB to be carried out in the next step. For example, the protective film PRF may include at least one of polyethylene terephthalate (PET), polypropylene (PP), polycarbonate (PC), polyethylene (PE), and polyvinyl chloride (PVC).

For example, the protective film PRF may include an adhesive layer thereunder. The adhesive layer may include at least one of silicon-based, polyurethane-based, and acrylic-based materials, but embodiments are not limited thereto.

In the manufacturing method S1 for the display device 10 according to an embodiment, since the coating layer CTL includes the inclined portion SA, the protective film PRF may be allowed to be in close contact with the mother substrate MSUB. For example, the protective film PRF may be concavely attached toward the mother substrate MSUB due to the presence of the inclined portion SA of the coating layer CTL. The protective film PRF may be in firm contact with the outer boundary CTLa and the inner boundary CTLb of the coating layer CTL. Accordingly, it is possible to prevent an etchant ECH from permeating along the top surface (or upper surface) of the sensor electrode layer SENL or the top surface (or upper surface) of the encapsulation layer ENC.

In the drawing, the concave portion of the protective film PRF is shown to be spaced apart from the first surface of the mother substrate MSUB. However, in some examples, the concave portion of the protective film PRF may be attached to the first surface of the mother substrate MSUB.

As illustrated in FIGS. 19 to 21, 26, 27, 31, and 32, the etchant may be sprayed on the second surface of the mother substrate MSUB without a separate mask to reduce the thickness of the mother substrate MSUB, the mother substrate may be cut along the first laser irradiation areas CH1 and the second laser irradiation areas CH2, and the protective film PRF may be detached (step S160 in FIG. 13).

In the case that the etchant is sprayed on the second surface of the mother substrate MSUB, the mother substrate MSUB may be reduced from the first thickness TH1 to the second thickness TH2. Since the mother substrate MSUB is etched without a separate mask, isotropic etching in which the mother substrate MSUB is uniformly etched over the entire area of the second surface may be performed.

Each of the first laser irradiation areas CH1 may include a physical hole formed by the first laser LR1 and an area around the physical hole of which physical properties are changed by the laser. In another example, each of the first laser irradiation areas CH1 may be an area of which physical properties are changed by the first laser LR1 without a physical hole. Accordingly, the etching rate in each of the first laser irradiation areas CH1 by the etchant may be higher than the etching rate in other areas of the mother substrate MSUB to which the laser is not irradiated.

In the case that the thickness of the mother substrate MSUB is reduced by the etchant and the etchant permeates into the first laser irradiation areas CH1 formed by the first laser LR1, due to the first laser irradiation areas CH1, a difference may occur in etching rates between an area in which the first laser irradiation areas CH1 are formed and an area in which the first laser irradiation areas CH1 are not formed. For example, the mother substrate MSUB may be performed with anisotropic etching in which the etching rate in the area in which the first laser irradiation areas CH1 are formed is faster than the etching rate in the area in which the first laser irradiation areas CH1 are not formed. Accordingly, as illustrated in FIG. 28, the substrate SUB separated from the mother substrate MSUB may include the first inclined surface IP1_1 disposed between the side surface SS1 and the bottom surface (or lower surface) BS.

For example, as the etchant permeates into the first laser irradiation areas CH1 formed by the first laser LR1, the mother substrate MSUB may be separated along a first cutting line CL1. For example, each of the display cells DPC may be separated from the mother substrate MSUB. The first cutting line CL1 may be formed along the first sketch line LS1. In an embodiment, as shown in FIG. 20, the outer boundary CTLa of the coating layer CTL may be positioned inside the first cutting line CL1. For example, the outer boundary CTLa of the coating layer CTL may be closer to the center portion of each display cell DPC than the first cutting line CL1.

Since the first surface of the substrate SUB separated from the mother substrate MSUB is not permeated by the etchant due to the protective film PRF but the second surface of the substrate SUB is etched by the etchant, the first surface and the second surface of the substrate SUB may have differences in roughness, hardness, light transmittance, light reflectivity, local density, surface chemical structure, or the like. For example, dimples due to the etchant may occur on the second surface of the substrate SUB. The dimple indicates that a fine defect such as a scratch present on the second surface of the substrate SUB is enlarged by reacting with the etchant.

For example, the one-side tolerance of the laser may be about 50 µm, and the width of the first laser irradiation area CH1 formed by the first laser LR1 may be expanded by about 40 µm by the etchant. Accordingly, considering the both-sides tolerance of the laser of each of the display cells DPC and the width of the first laser irradiation area CH1 expanded by the etchant, a separation distance SD between the display cells DPC adjacent to each other may be about 280 µm, but embodiments are not limited thereto.

Each of the second laser irradiation areas CH2 may include a physical hole formed by the second laser LR2 and an area around the physical hole of which physical properties are changed by the laser. In another example, each of the second laser irradiation areas CH2 may be an area of which physical properties are changed by the second laser LR2 without a physical hole. Accordingly, the etching rate in each of the second laser irradiation areas CH2 by the etchant may be higher than the etching rate in other areas of the mother substrate MSUB to which the laser is not irradiated.

Due to the anisotropic etching, as illustrated in FIG. 33, the substrate SUB separated from the mother substrate MSUB may include the second inclined surface IP1_2 disposed between the bottom surface (or lower surface) BS and the side surface SS2 of the edge portion TEG of the through hole TH.

For example, as the etchant permeates into the second laser irradiation areas CH2 formed by the second laser LR2, the mother substrate MSUB may be separated along a second cutting line CL2 to form the through hole TH. The second cutting line CL2 may be formed along the second sketch line LS2. In an embodiment, as illustrated in FIG. 20, the inner boundary CTLb of the coating layer CTL may be positioned outside the second cutting line CL2.

As illustrated in FIGS. 26 and 31, since the depth of each of the second laser irradiation areas CH2 is deeper than the depth of each of the first laser irradiation areas CH1, the etchant may permeate into the second laser irradiation areas CH2 earlier than the first laser irradiation areas CH1. For example, since the second laser irradiation areas CH2 are etched along with a slimming process in which the thickness of the mother substrate MSUB is reduced by the etchant, the substrate SUB may form a tapered cross section by isotropic etching in the through hole TH formed by the second laser irradiation area CH2. In comparison, the first laser irradiation areas CH1 are not etched in the case that slimming is performed. Accordingly, a difference may occur between the length and angle of the inclination direction of the first inclined surface IP1_1 in the edge portion of the substrate SUB formed by the first laser irradiation areas CH1, and the length and angle of the inclined direction of the second inclined surface IP1_2 in the through hole TH formed by the second laser irradiation areas CH2.

After the etching process is completed, the protective film PRF may be detached (or removed).

Through the etching process, each of the display cells DPC may be separated from the mother substrate MSUB, and the through hole TH may be formed in each of the display cells DPC.

As illustrated in FIGS. 22, 28, and 33, the driving IC 200 and the circuit board 300 may be attached to each of the display cells DPC, and the coating layer CTL may be detached from each of the display cells DPC (step S170 in FIG. 13).

In some embodiments, in the case that the coating layer CTL is detached, the adhesive force of the coating layer CTL may be different in the inclined portion SA and the flat portion FA. The adhesive force of the coating layer CTL in the inclined portion SA may be in the range of about 10 gf/inch to about 150 gf/inch, and the adhesive force of the coating layer CTL in the flat portion FA may be in the range of about 5 gf/inch to about 10 gf/inch.

As described above, by using the laser and the etching process, the thickness of the substrate SUB may be reduced, the substrate SUB of each of the display cells DPC may be separated from the mother substrate MSUB, and at the same time the through hole TH may be formed, so that the efficiency of the manufacturing process may be increased.

In concluding the detailed description, those skilled in the art will appreciate that many variations and modifications may be made to the embodiments without substantially departing from the principles of the disclosure. Therefore, the disclosed embodiments of the invention are used in a generic and descriptive sense only and not for purposes of limitation.

## Claims

1. A display device comprising:
a display panel comprising a display area and a non-display area adjacent to a side of the display area; and
a residue trace disposed on the display panel, and disposed on the display area and the non-display area,
wherein an outer boundary of the residue trace is disposed adjacent to an edge portion of the display panel, and disposed to be closer to a center portion of the display panel than the edge portion of the display panel.

2. The display device of claim 1, wherein the outer boundary of the residue trace is surrounded by an outer boundary of the display panel in plan view.

3. The display device of claim 1 or claim 2, wherein
the display panel comprises a crack dam adj acent to the edge portion of the display panel, and
the outer boundary of the residue trace is closer to the center portion of the display panel than the crack dam.

4. The display device of any one of claims 1 to 3, wherein
the display panel comprises a through hole penetrating the display panel and disposed in the display area, and
the residue trace comprises an opening surrounding the through hole, optionally wherein the opening of the residue trace is larger than the through hole of the display panel in plan view, further optionally wherein the opening of the residue trace and the through hole of the display panel have different sizes and a same shape in plan view.

5. A display device comprising:
a display panel comprising at least one conductive layer and at least one non-conductive layer disposed on the conductive layer; and
a residue trace disposed on at least a part of the non-conductive layer,
wherein a light transmittance of the non-conductive layer in a first area, in which the residue trace is disposed, is different from a light transmittance of the non-conductive layer in a second area in which the residue trace is not disposed.

6. The display device of claim 5, wherein:
(i) the residue trace is smaller than the display panel in plan view; and/or
(ii) the residue trace includes at least one of acrylic resin, epoxy resin, and urethane resin; and/or
(iii) the residue trace is formed in a process in which a part of the non-conductive layer is removed.

7. The display device of claim 5 or claim 6, wherein
the display panel comprises:
a substrate;
a light emitting element layer disposed on the substrate; and
an encapsulation layer disposed on the light emitting element layer, and
the residue trace is disposed on the encapsulation layer, optionally wherein
the encapsulation layer comprises:
a first encapsulation inorganic layer,
an organic layer disposed on the first encapsulation inorganic layer, and
a second encapsulation inorganic layer disposed on the organic layer, and
the residue trace is disposed on the second encapsulation inorganic layer.

8. The display device of claim 5 or claim 6, wherein
the display panel comprises:
a substrate;
a light emitting element layer disposed on the substrate;
an encapsulation layer disposed on the light emitting element layer; and
a sensor electrode layer disposed on the encapsulation layer, and
the residue trace is disposed on the sensor electrode layer, optionally wherein
the sensor electrode layer comprises a sensor electrode and a sensor insulating layer, and
the residue trace is disposed on the sensor insulating layer.

9. A method of manufacturing a display device, the method comprising:
forming a plurality of display cells on a mother substrate;
forming a coating layer on each of the plurality of display cells;
forming a plurality of first laser irradiation areas by irradiating a first laser to the mother substrate;
attaching a protective film on the mother substrate; and
cutting the mother substrate along the plurality of first laser irradiation areas by spraying an etchant on the mother substrate without a mask.

10. The method of claim 9, wherein the forming of the coating layer comprises:
applying resin; and
curing the resin, optionally wherein the resin is applied by a printing process.

11. The method of claim 9 or claim 10, wherein the coating layer comprises an inclined surface at an end portion of the coating layer.

12. The method of claim 11, wherein an angle of a tangent line with respect to the inclined surface at the end portion of the coating layer is equal to or less than about 30 degrees.

13. The method of claim 11 or claim 12, wherein the coating layer comprises:
an inclined portion adjacent to the end portion of the coating layer; and
a flat portion disposed on a side of the inclined portion.

14. The method of claim 13, further comprising:
removing the coating layer,
wherein in the removing of the coating layer, an adhesive force of the coating layer in the inclined portion is greater than an adhesive force of the coating layer in the flat portion, optionally wherein
the adhesive force of the coating layer in the inclined portion is about 10 gf/inch to about 150 gf/inch, and
the adhesive force of the coating layer in the flat portion is about 5 gf/inch to about 10 gf/inch.

15. The method of any one of claims 9 to 14, wherein:
(i) the coating layer includes at least one of acrylic resin, epoxy resin, and urethane resin; and/or
(ii) an average thickness of the coating layer is about 40 µm to about 150 µm; and/or
(iii) the protective film includes at least one of polyethylene terephthalate (PET), polypropylene (PP), polycarbonate (PC), polyethylene (PE), and polyvinyl chloride (PVC), optionally wherein
the protective film comprises an adhesive layer, and
the adhesive layer includes at least one of silicone-based, polyurethane-based, and acrylic-based materials.
